(19) Europäisches Patentamt
European Patent Office
Office européen des brevets

(11) EP 1 930 964 A1

(12) **EUROPEAN PATENT APPLICATION**
published in accordance with Art. 153(4) EPC

(43) Date of publication:
**11.06.2008 Bulletin 2008/24**

(21) Application number: **06746449.5**

(22) Date of filing: **16.05.2006**

(51) Int Cl.:
***H01L 51/50*** $^{(2006.01)}$ ***C09K 11/06*** $^{(2006.01)}$

(86) International application number:
**PCT/JP2006/309735**

(87) International publication number:
**WO 2007/039952 (12.04.2007 Gazette 2007/15)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.09.2005 JP 2005288464**

(71) Applicant: **Idemitsu Kosan Co., Ltd.**
**Chiyoda-ku**
**Tokyo 100-8321 (JP)**

(72) Inventors:
- **YABUNOUCHI, Nobuhiro**
**Sodegaura-shi, Chiba 2990293 (JP)**
- **KAWAMURA, Masahiro**
**Sodegaura-shi, Chiba 2990293 (JP)**
- **ARAKANE, Takashi**
**Sodegaura-shi, Chiba 2990293 (JP)**
- **TOKAILIN, Hiroshi**
**Sodegaura-shi, Chiba 2990293 (JP)**
- **FUKUOKA, Kenichi**
**Sodegaura-shi, Chiba 2990293 (JP)**

(74) Representative: **Gille Hrabal Struck Neidlein Prop Roos**
**Patentanwälte**
**Brucknerstrasse 20**
**40593 Düsseldorf (DE)**

(54) **ORGANIC ELECTROLUMINESCENT DEVICE**

(57) An organic electroluminescent device (1) comprising, a cathode (80), an anode (20), an emitting layer (50) provided between the cathode and the anode, and at least a first layer (30) and a second layer (40) stacked between the anode (20) and the emitting layer (50) in this order from the anode (20) side, the first layer (30) having a hole mobility of $7.0 \times 10^{-4}$ ($cm^2$/Vs, electric field intensity: $2.5 \times 10^4$ (V/cm)) or more, the second layer (40) having a hole mobility of $7.0 \times 10^{-4}$ ($cm^2$/Vs, electric field intensity: $2.5 \times 10^4$ (V/cm)) or more, and a main compound which forms the first layer (30) differing from a main compound which forms the second layer (40).

FIG.1

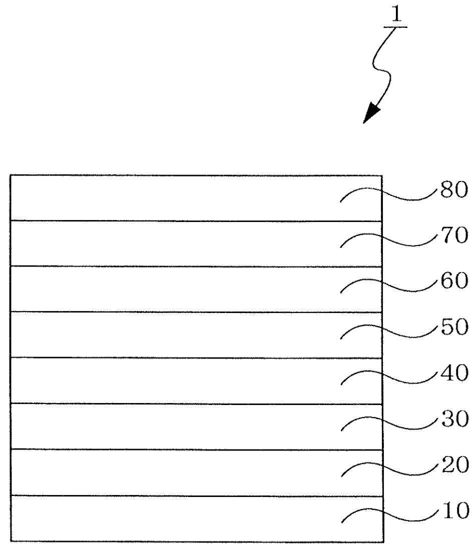




Printed by Jouve, 75001 PARIS (FR)

**Description**

TECHNICAL FIELD

The invention relates to an organic electroluminescent device. In particular, the invention relates to an organic electroluminescent device in which at least a first layer and a second layer are provided between an anode and an emitting layer.

TECHNICAL BACKGROUND

An organic electroluminescent device ("organic EL device") is a self-emitting device utilizing the principle that a fluorescent substance emits light due to energy produced when holes injected from an anode and electrons injected from a cathode recombine upon application of an electric field. An organic EL device using an organic material has been extensively studied since a low-voltage-drive organic EL device having a stacked structure was reported by C. W. Tang et al. of Eastman Kodak (non-patent document 1).

In the organic EL device reported by Tang et al., tris(8-hydroxyquinolinol)aluminum is used for an emitting layer, and a triphenyldiamine derivative is used for a hole transporting layer. The stacked structure has advantages in that holes are efficiently injected into the emitting layer, excitons are efficiently generated upon recombination since electrons injected from the cathode are blocked, and excitons generated in the emitting layer are confined, for example. As the structure of the organic EL device, a two-layer structure including a hole transporting (injecting) layer and an electron transporting/emitting layer, a three-layer structure including a hole transporting (injecting) layer, an emitting layer, and an electron transporting (injecting) layer, and the like have been known. The structure and the formation method for such a stacked structure device have been studied in order to improve the recombination efficiency of injected holes and electrons.

As the hole injecting material, compounds such as phthalocyanine, amorphous carbon, and polyamine have been reported. However, since phthalocyanine exhibits high crystallinity, a dark spot occurs due to a short circuit, dielectric breakdown, or the like. It is necessary to increase the film thickness of the hole injecting material in order to prevent leakage and adjust chromaticity. On the other hand, phthalocyanine and amorphous carbon show coloring or the like when increasing the film thickness. As the polyamine, a dendrimer material (patent document 1), a tetraamine material (patent document 2), and the like have been reported. However, these materials exhibit low luminous efficiency, require a high drive voltage, and show an insufficient luminous lifetime. As a high-mobility material, N,N'-bis(4'0-diphenylamino-4-biphenyl)-N,N'-diphenylbenzidi ne is known. Such a material is generally used as a hole transporting material.

A patent document in which mobility is measured has been published. On the other hand, this document does not describe the electric field intensity although the mobility varies depending on the electric field intensity during measurement (patent document 3). The compound disclosed in this document was evaluated. It was found that a high drive voltage is required and the luminous lifetime is insufficient.

[Patent document 1] JP-A-4-308688

[Patent Document 2] JP-A-7-126226

[Patent Document 3] JP-A-2005-166680

[Non-patent document 1] C. W. Tang, S. A. Vanslyke, Applied Physics Letters, vol. 51, p. 913, 1987

As described above, an organic EL device has been reported which exhibits a long lifetime, is driven at a low voltage, and exhibits high efficiency. However, the characteristics of the reported organic EL device are not necessarily sufficient. Therefore, development of an organic EL device exhibiting a more excellent performance has been strongly demanded.

The invention was achieved in order to solve the above problems. An object of the invention is to provide an organic EL device which exhibits a long lifetime, is driven at a low voltage, and exhibits a high efficiency.

SUMMARY OF THE INVENTION

The inventors of the invention conducted extensive studies in order to achieve the above object. As a result, the inventors found that the above problems can be solved by stacking two specific layers between the anode and the emitting layer. This finding has led to the completion of the invention.

According to the invention, the following organic EL device is provided.

1. An organic electroluminescent device comprising,
a cathode, an anode, an emitting layer provided between the cathode and the anode, and
at least a first layer and a second layer stacked between the anode and the emitting layer in this order from the anode side,

the first layer having a hole mobility of 7. $0\times10^{-4}$ ($cm^2/Vs$, electric field intensity: $2.5\times10^4$ (V/cm)) or more, the second layer having a hole mobility of $7.0\times10^{-4}$ ($cm^2/Vs$, electric field intensity: $2.5\times10^4$ (V/cm)) or more, and a main compound which forms the first layer differing from a main compound which forms the second layer.

2. An organic electroluminescent device comprising, a cathode, an anode, an emitting layer provided between the cathode and the anode, and at least a first layer and a second layer stacked between the anode and the emitting layer in this order from the anode side, the first layer having a hole mobility of $7.0\times10^{-4}$ ($cm^2/Vs$, electric field intensity: $2.5\times10^4$ (V/cm)) or more, the second layer having a hole mobility/thickness relationship of hole mobility $\mu$ ($cm^2/Vs$)/thickness d (nm) > $3.0\times10^2$ (cm/Vs), and a main compound which forms the first layer differing from a main compound which forms the second layer.

3. The organic electroluminescent device according to 1 or 2, wherein the main compound which forms the first layer is an aromatic amine derivative.

4. The organic electroluminescent device according to 3, wherein the aromatic amine derivative is a compound of the following general formula (1),

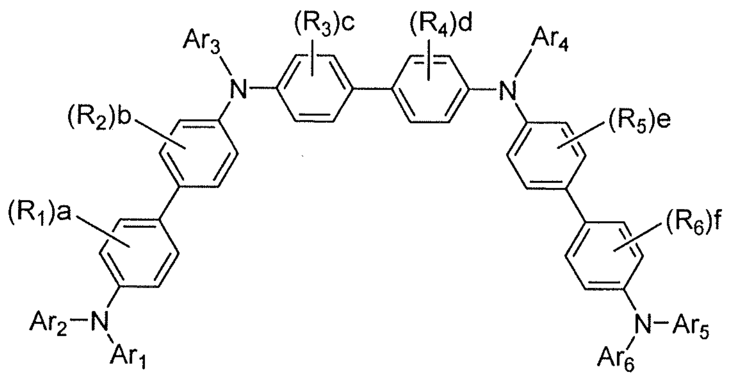

(1)

wherein $R_1$ to $R_6$ independently represent hydrogen, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; a, b, c, d, e, and f independently represent an integer of from 0 to 4; provided that $R_1$ to $R_6$ may be bonded to form a saturated or unsaturated substituted or unsubstituted five-membered or six-membered ring structure; and $Ar_1$ to $Ar_6$ independently represent a substituted or unsubstituted substituent having 6 to 50 nucleus atoms.

5. The organic electroluminescent device according to 3, wherein the aromatic amine derivative is a compound of the following general formula (2),

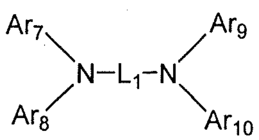

(2)

wherein $L_1$ represents a divalent group of a substituted or unsubstituted arylene group having 5 to 60 carbon atoms or a heterocyclic group, and $Ar_7$ to $Ar_{10}$ independently represent a substituted or unsubstituted substituent having 5 to 50 nucleus atoms or a substituent of the following general formula (3),

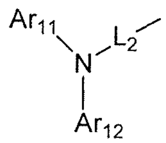

(3)

wherein $L_2$ represents a divalent group selected from a substituted or unsubstituted arylene group having 5 to 60 carbon atoms or a heterocyclic group, and $Ar_{11}$ and $Ar_{12}$ independently represent a substituted or unsubstituted substituent having 5 to 50 nucleus atoms.

6. The organic electroluminescent device according to 5, wherein at least one of $L_1$ and $L_2$ is biphenylene, terphenylene, phenanthrene, or fluorenylene.

7. The organic electroluminescent device according to 5 or 6, wherein at least one of $Ar_7$ to $Ar_{12}$ is a biphenyl group, terphenyl group, phenanthrene group, fluorenyl group, 1-naphthyl group, 2-naphthyl group, or phenyl group.

8. The organic electroluminescent device according to any one of 1 to 7, wherein the main compound which forms the second layer is an aromatic amine derivative of the following general formula (4),

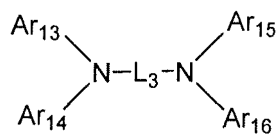

(4)

wherein $L_3$ represents a divalent group of a substituted or unsubstituted arylene group having 5 to 60 carbon atoms or a heterocyclic group; $Ar_{13}$ to $Ar_{16}$ independently represent a substituted or unsubstituted substituent having 5 to 50 nucleus atoms; and the substituent of $Ar_{13}$ to $Ar_{16}$ is a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group.

9. The organic electroluminescent device according to any one of 1 to 7, wherein the main compound which forms the second layer is an aromatic amine derivative of the following general formula (5),

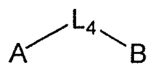

(5)

wherein A is shown by the following general formula (6), and B is shown by the following general formula (7),

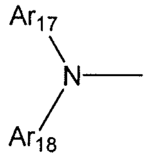

(6)

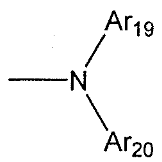

(7)

wherein $Ar_{17}$ to $Ar_{20}$ independently represent a substituted or unsubstituted substituent having 5 to 50 nucleus atoms, provided that A and B are not the same, and

$L_4$ represents a divalent group of a substituted or unsubstituted arylene group having 5 to 60 carbon atoms or a heterocyclic group.

10. The organic electroluminescent device according to any one of 1 to 7, wherein the main compound which forms the second layer is an aromatic amine derivative of the following general formula (8),

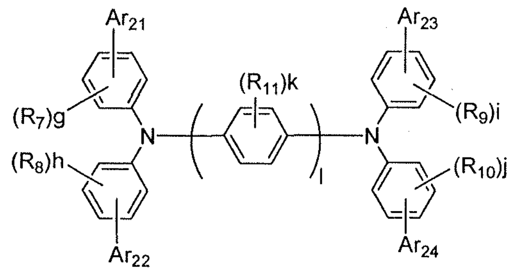

(8)

wherein $R_7$ to $R_{11}$ independently represent hydrogen, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; g, h, i, and j independently represent an integer of 0 to 4; k represents an integer of 0 to 4; l represents an integer of 1 to 3; provided that $R_7$ to $R_{11}$ may be bonded to form a saturated or unsaturated substituted or unsubstituted five-membered or six-membered ring structure; and $Ar_{21}$ to $Ar_{24}$ independently represent a substituted or unsubstituted substituent having 5 to 50 nucleus atoms.

11. The organic electroluminescent device according to any one of 1 to 7, wherein the main compound which forms the second layer is an aromatic amine derivative of the following general formula (9),

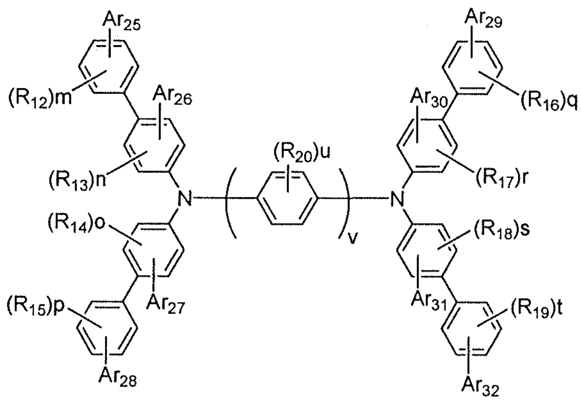

(9)

wherein $R_{12}$ to $R_{20}$ independently represent a hydrogen atom, a substituted or unsubstituted aryl group having 5 to

50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; m, p, q, and t independently represent an integer of 0 to 4; n, o, r, s, and u independently represent an integer of 0 to 3; v represents an integer of 1 to 3; provided that $R_{12}$ to $R_{20}$ may be bonded to form a saturated or unsaturated substituted or unsubstituted five-membered or six-membered ring structure; and $Ar_{25}$ to $Ar_{32}$ independently represent a substituted or unsubstituted substituent having 5 to 50 nucleus atoms.

12. The organic electroluminescent device according to any one of 1 to 11, wherein the first layer has a thickness of 40 to 1000 nm.

13. The organic electroluminescent device according to any one of 1 to 12, wherein the second layer has a thickness of 2 to 60 nm.

14. The organic electroluminescent device according to any one of 1 to 13, wherein the main compound which forms the first layer has an ionization potential lower than the ionization potential of the main compound which forms the second layer.

15. The organic electroluminescent device according to any one of 1 to 14, wherein the main compound which forms the second layer has a singlet energy gap of 3.0 to 3.8 eV, which is greater than the singlet energy gap of the main compound which forms the first layer.

16. The organic electroluminescent device according to any one of 1 to 15, wherein the main compound which forms the second layer has a triplet energy gap of 2.5 eV or more.

17. The organic electroluminescent device according to any one of 1 to 16, wherein the emitting layer contains an arylamine compound and/or a styryl amine compound.

18. The organic electroluminescent device according to any one of 1 to 17, which emits blue light.

According to the invention, an organic EL device can be provided which exhibits a long lifetime, is driven at a low voltage, and exhibits a high efficiency.

BRIEF DESCRIPTION OF THE DRAWINGS

FIG. 1 is a view showing one embodiment of an organic EL device according to the invention.

BEST MODES FOR CARRING OUT THE INVENTION

In an organic EL device according to the invention in which at least an emitting layer is provided between a cathode and an anode, at least a first layer and a second layer are stacked between the anode and the emitting layer in this order from the anode side.

The first layer has a hole mobility of $7.0\times10^{-4}$ ($cm^2/Vs$, electric field intensity: $2.5\times10^4$ (V/cm)) or more, and preferably $10.0\times10^{-4}$ ($cm^2/Vs$, electric field intensity: $2.5\times10^4$ (V/cm)) or more.

The second layer has a hole mobility of $7.0\times10^{-4}$ ($cm^2/Vs$, electric field intensity: $2.5\times10^4$ (V/cm)) or more, and preferably $8.0\times10^{-4}$ ($cm^2/Vs$, electric field intensity: $2.5\times10^4$ (V/cm)) or more.

A main compound which forms the first layer differs from a main compound which forms the second layer.

In another organic EL device according to the invention in which at least an emitting layer is provided between a cathode and an anode, at least a first layer and a second layer are stacked between the anode and the emitting layer in this order from the anode side.

The first layer has a hole mobility of $7.0\times10^{-4}$ ($cm^2/Vs$, electric field intensity: $2.5\times10^4$ (V/cm)) or more, and preferably $10.0\times10^{-4}$ ($cm^2/Vs$, electric field intensity: $2.5\times10^4$ (V/cm)) or more.

The second layer has a hole mobility/thickness relationship of hole mobility $\mu$ ($cm^2/Vs$)/thickness d (nm) > $3.0\times10^2$ (cm/Vs), and preferably $\mu/d > 4.0\times10^3$ (cm/Vs).

A main compound which forms the first layer differs from a main compound which forms the second layer.

FIG. 1 is a cross-sectional view showing an example of the organic EL device according to the invention.

An organic EL device 1 has a configuration in which an anode 20, a first layer 30, a second layer 40, an emitting layer 50, an electron transporting layer 60, an electron injecting layer 70, and a cathode 80 are stacked on a substrate 10 in this order. The organic EL device may have various other configurations.

The main compound which forms the first layer is an aromatic amine derivative.

As a preferred example of the aromatic amine derivative, a compound of the following general formula (1) can be given.

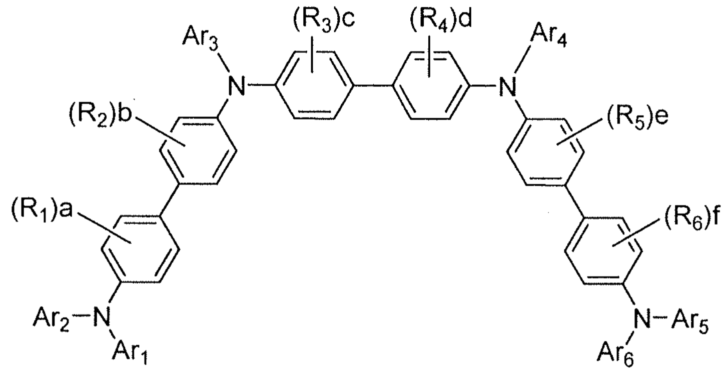

(1)

wherein $R_1$ to $R_6$ independently represent hydrogen, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; a, b, c, d, e, and f independently represent an integer of from 0 to 4; provided that $R_1$ to $R_6$ may be bonded to form a saturated or unsaturated substituted or unsubstituted five-membered or six-membered ring structure; and $Ar_1$ to $Ar_6$ independently represent a substituted or unsubstituted substituent having 6 to 50 nucleus atoms.

In the general formula (1), when a to f are plural numbers, $R_1$s to $R_6$s may be respectively the same or different.

$R_1$ to $R_6$ are preferably hydrogen or an alkyl group having 1 to 4 carbon atoms, and still more preferably hydrogen. a, b, c, d, e, and f are preferably 0 or 1, and still more preferably 0.

$Ar_1$ to $Ar_6$ are preferably aryl groups having 6 to 20 carbon atoms, more preferably a phenyl group, a naphthyl group, or a biphenyl group, and still more preferably a phenyl group or a naphthyl group.

A compound of the following general formula (2) is also preferably used as the aromatic amine derivative.

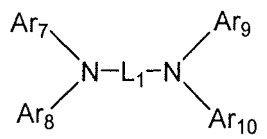

(2)

wherein $L_1$ represents a divalent group of a substituted or unsubstituted arylene group having 5 to 60 carbon atoms or a heterocyclic group, and $Ar_7$ to $Ar_{10}$ independently represent a substituted or unsubstituted substituent having 5 to 50 nucleus atoms or a substituent of the following general formula (3).

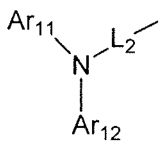

(3)

wherein $L_2$ represents a divalent group of a substituted or unsubstituted arylene group having 5 to 60 carbon atoms or a heterocyclic group, and $Ar_{11}$ and $Ar_{12}$ independently represent substituted or unsubstituted substituents having 5 to 50 nucleus atoms.

In the general formula (2), when a plurality of $L_2$s exist, the $L_2$s may be the same or different. When a plurality of $Ar_{11}$s and $Ar_{12}$s exist, the $Ar_{11}$s and $Ar_{12}$s may be respectively the same or different.

It is preferable that at least one of the divalent groups represented by $L_1$ in the formula (2) and $L_2$ in the formula

(3) be phenylene, biphenylene, terphenylene, phenanthrene, fluorenylene, or a divalent group of the following formula, and still more preferably terphenylene or phenanthrene.

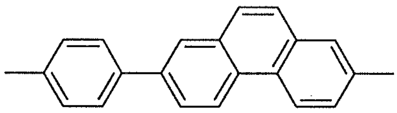

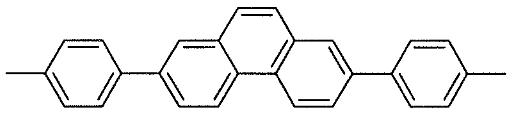

$Ar_7$ to $Ar_{12}$ are preferably aryl groups having 6 to 20 carbon atoms.
It is preferable that at least one of $Ar_7$ to $Ar_{12}$ be a biphenyl group, substituted or unsubstituted terphenyl group, phenanthrenyl group, substituted or unsubstituted fluorenyl group, 1-naphthyl group, 2-naphthyl group, or phenyl group, more preferably a fluorenyl group, 1-naphthyl group, 2-naphthyl group, or phenyl group, and still more preferably a 1-naphthyl group or a phenyl group.

Specific examples of the aromatic amine derivative which forms the first layer are given below.

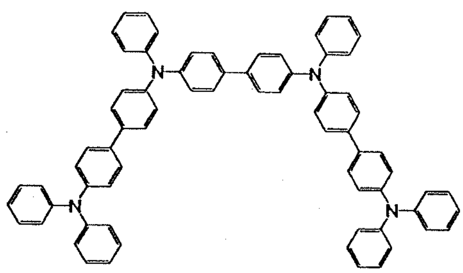

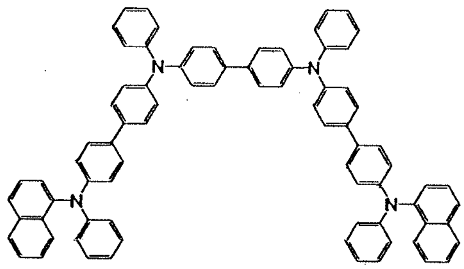

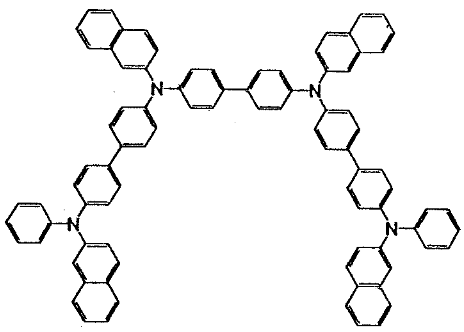

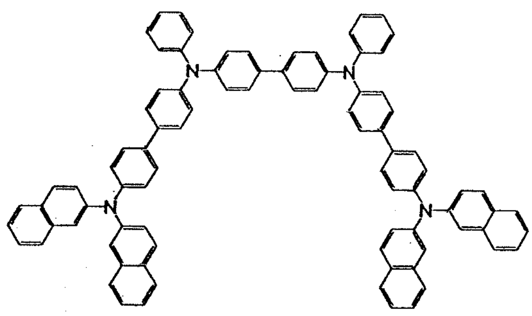

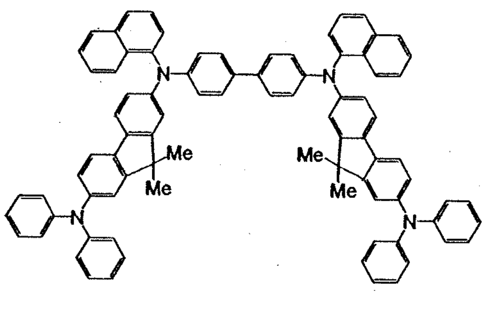

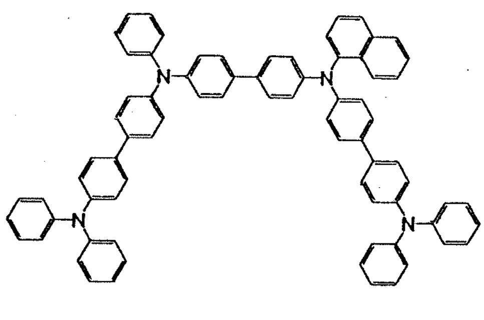

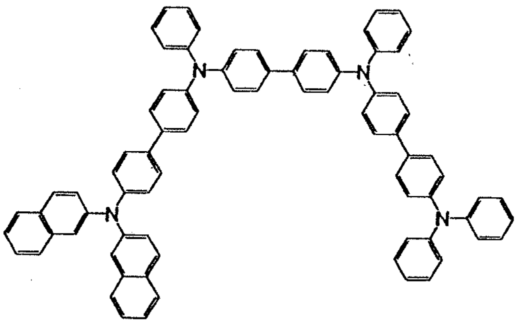

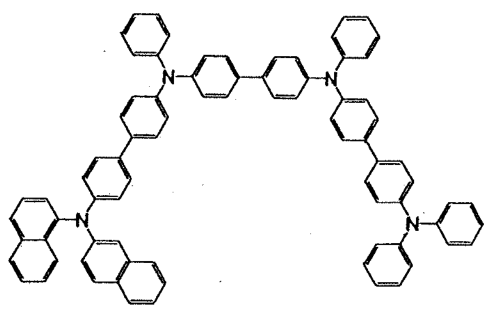

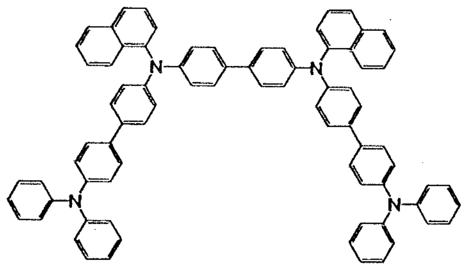

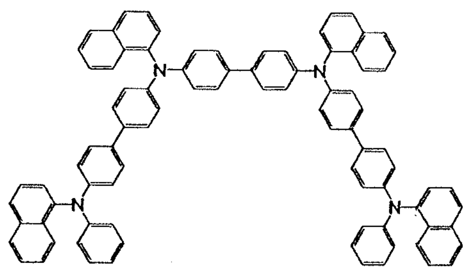

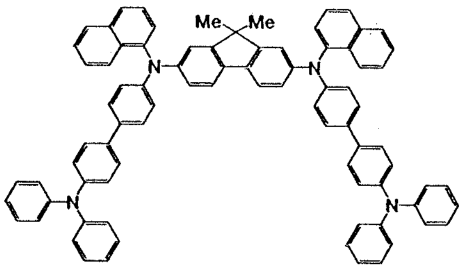

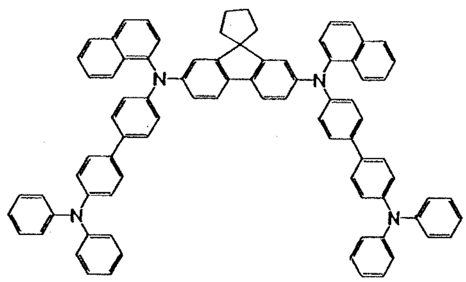

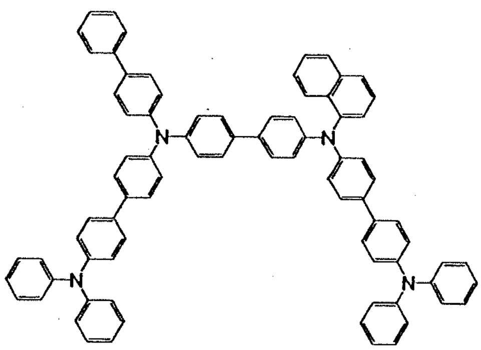

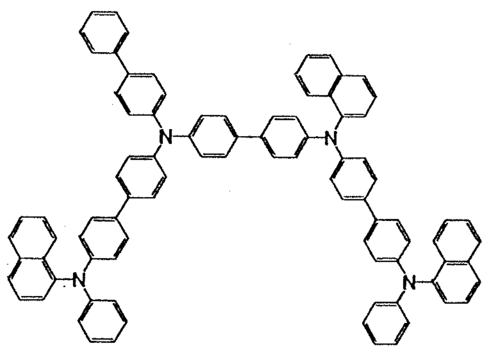

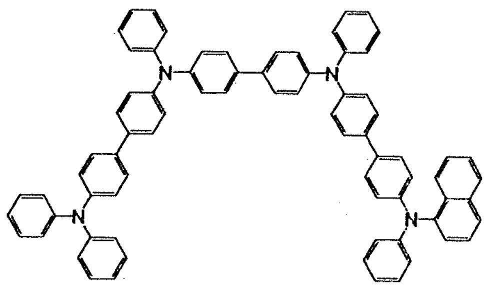

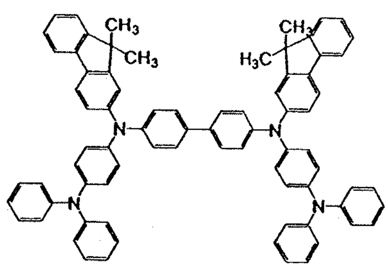

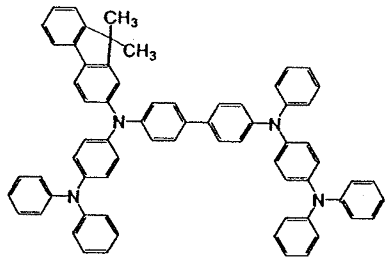

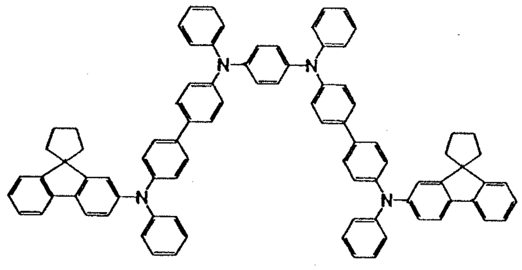

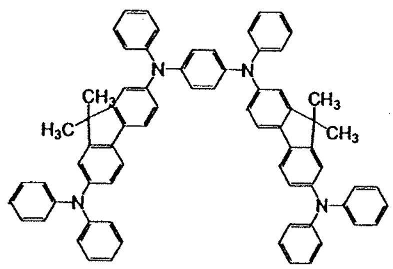

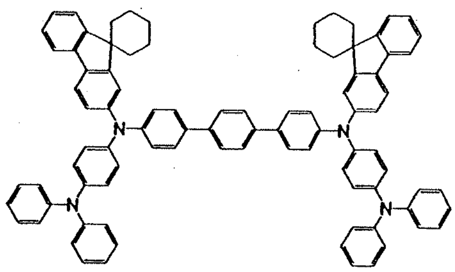

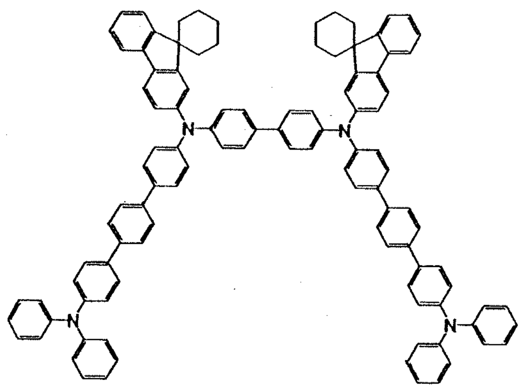

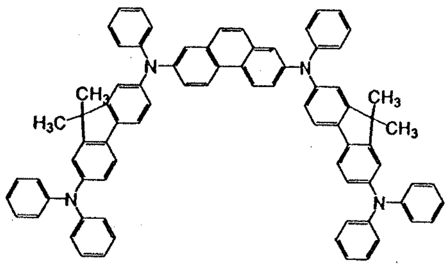

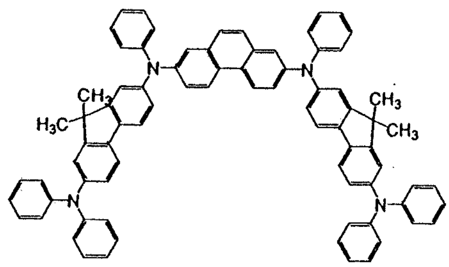

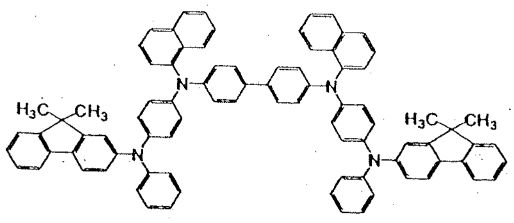

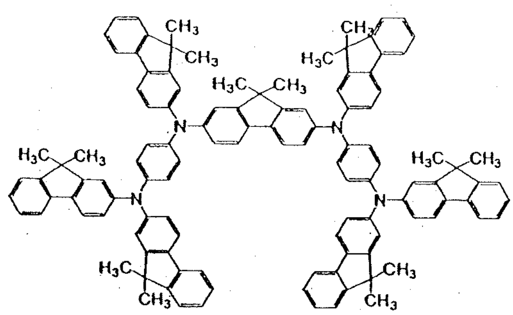

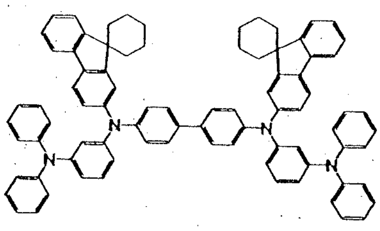

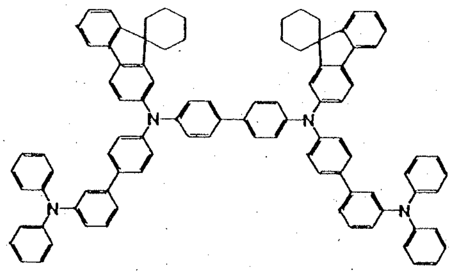

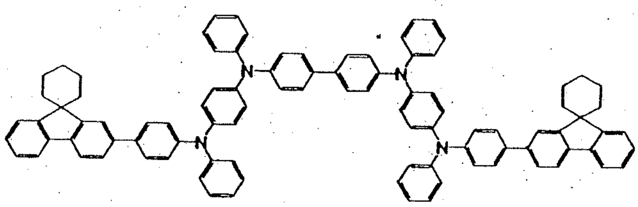

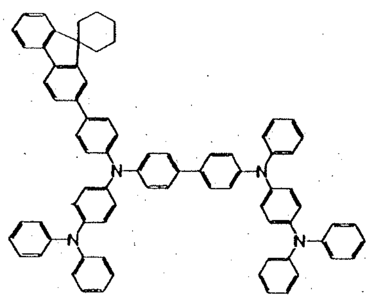

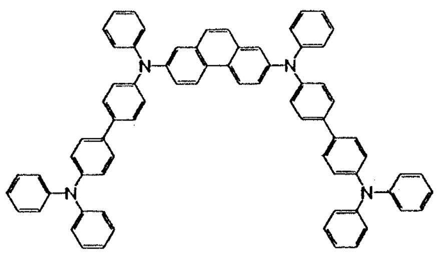

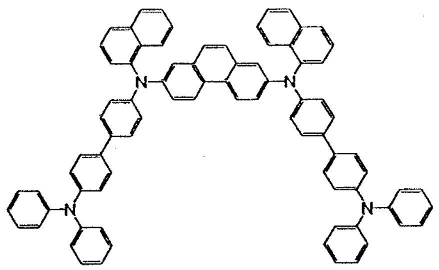

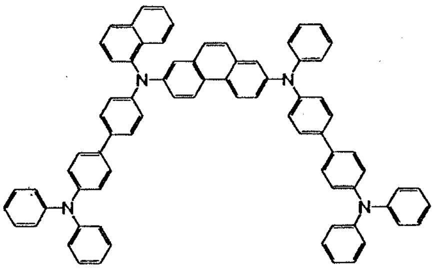

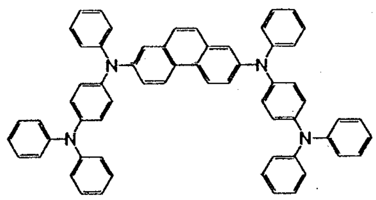

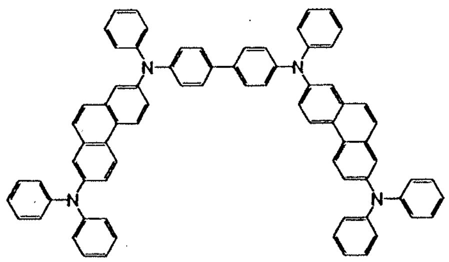

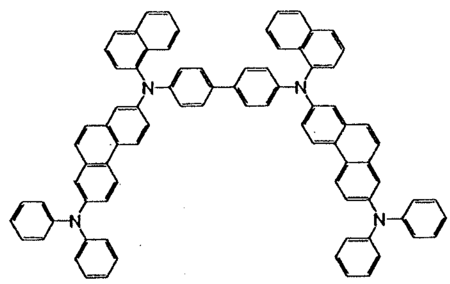

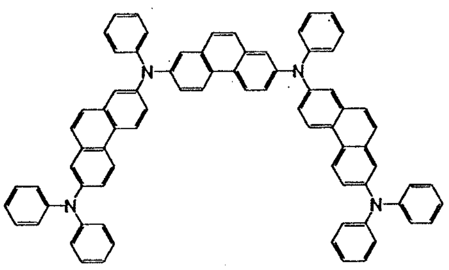

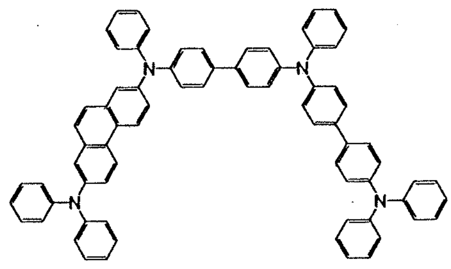

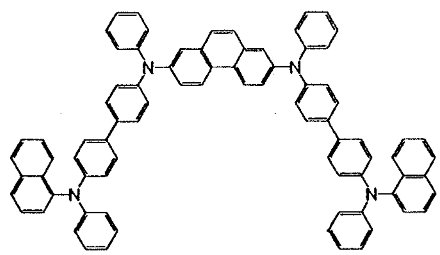

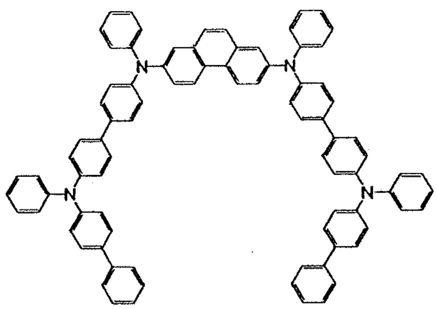

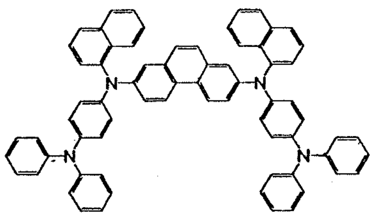

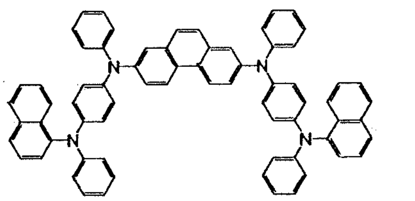

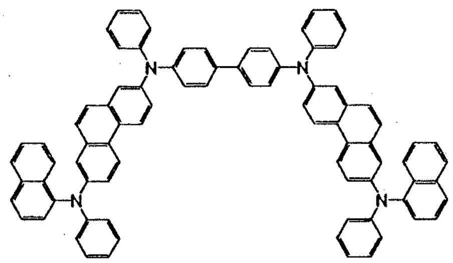

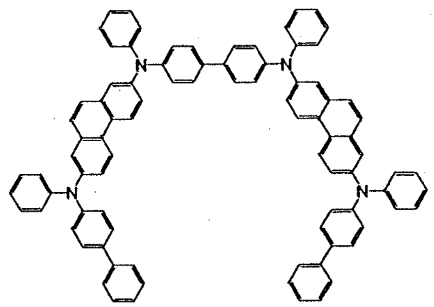

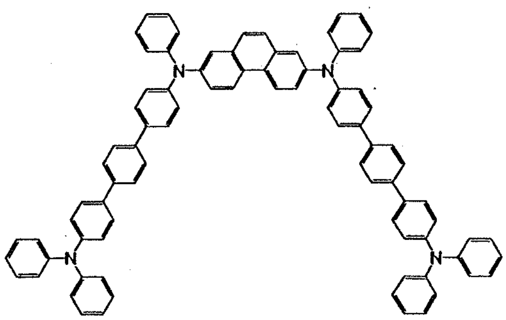

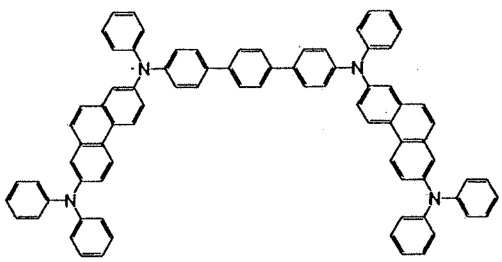

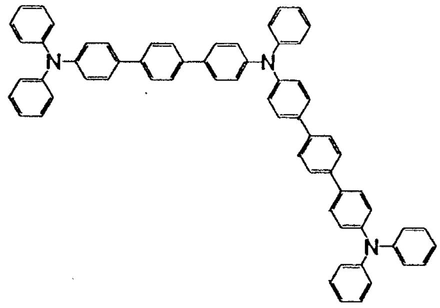

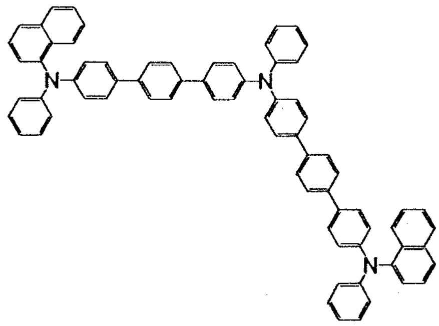

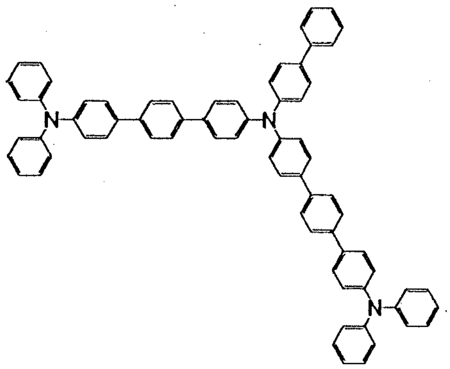

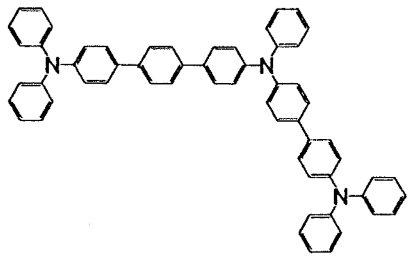

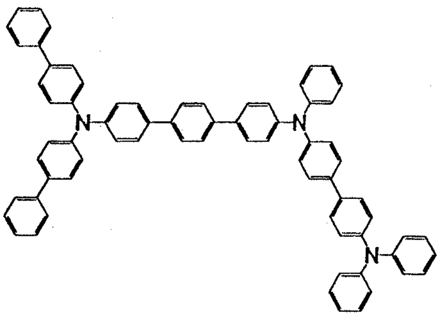

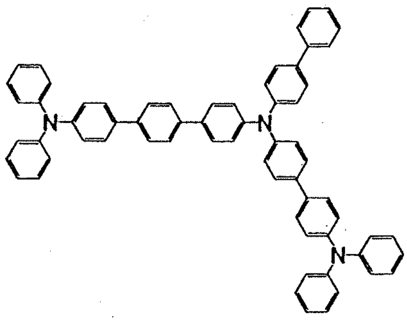

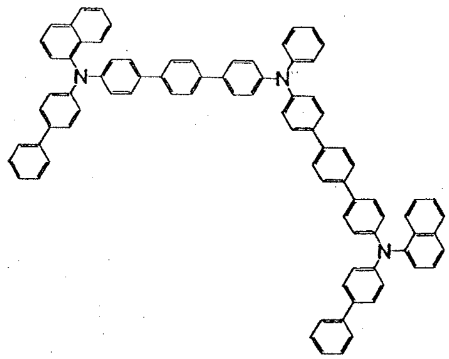

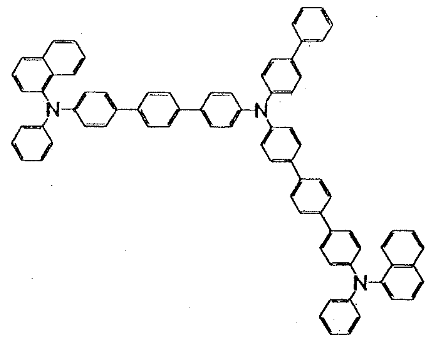

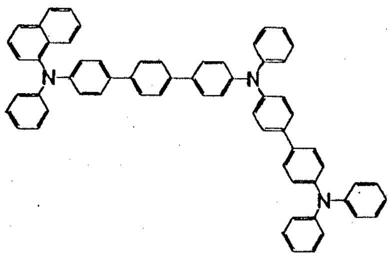

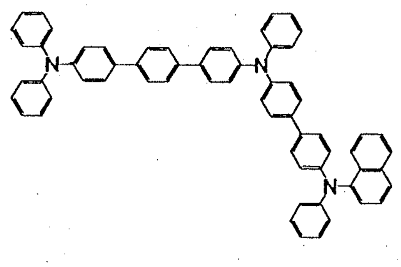

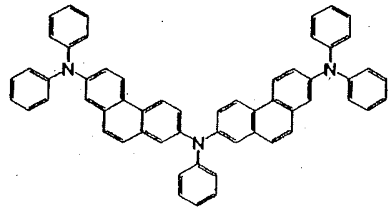

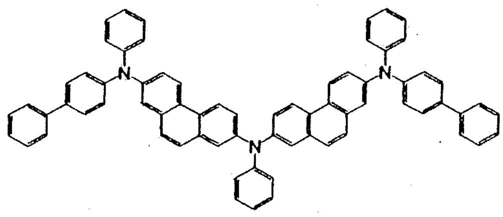

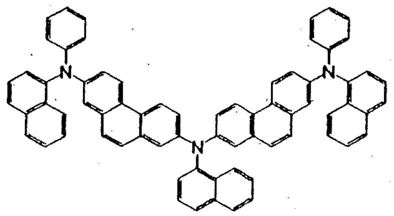

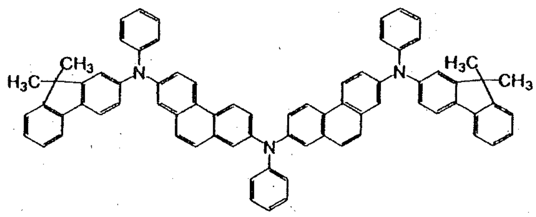

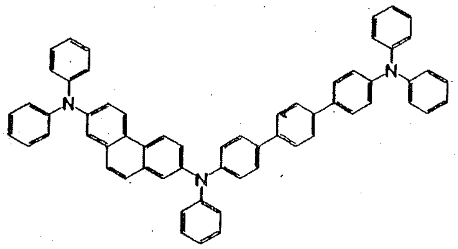

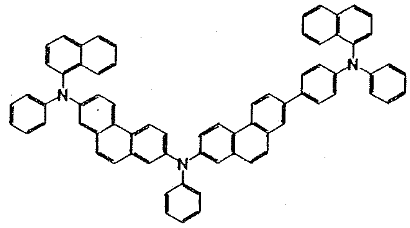

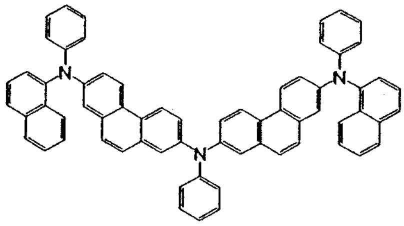

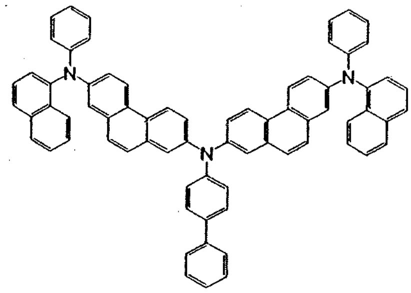

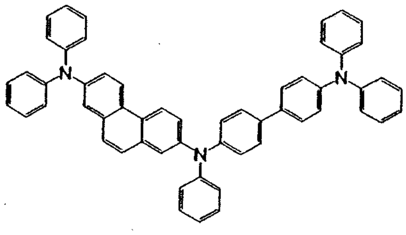

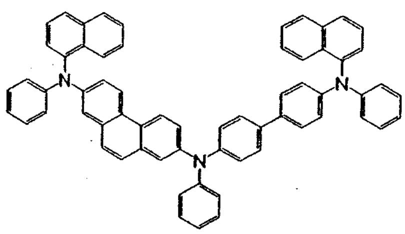

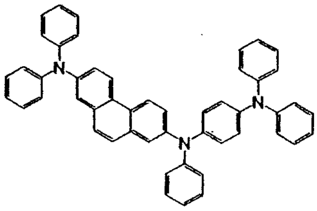

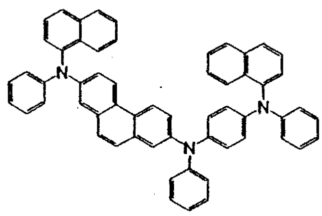

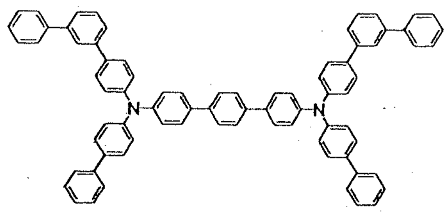
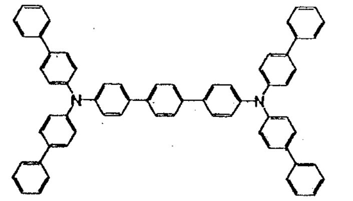

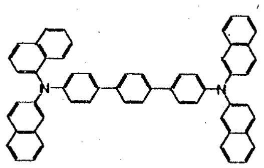
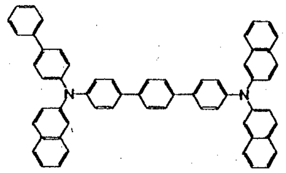
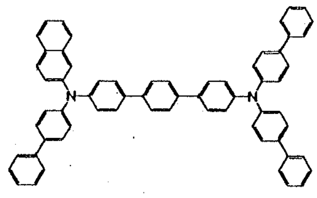

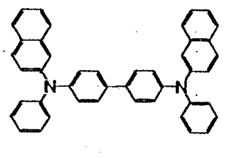
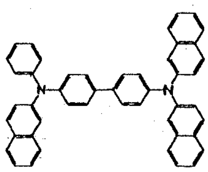
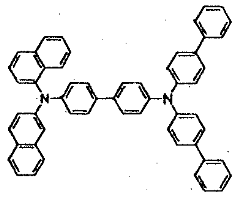
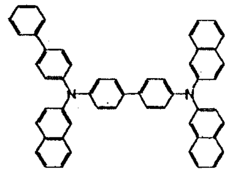

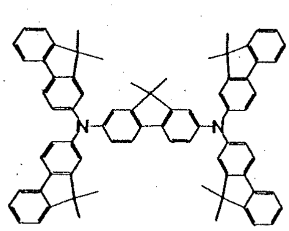
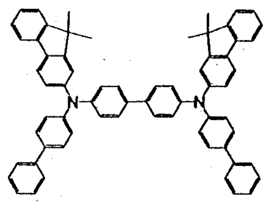
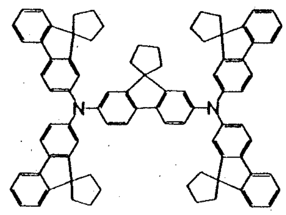

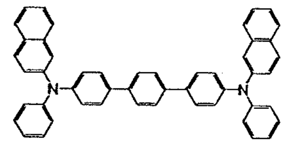

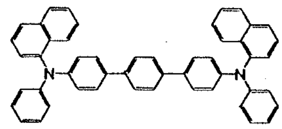

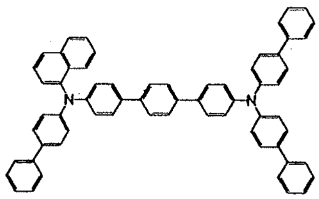

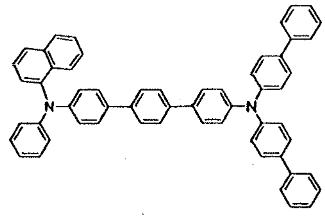

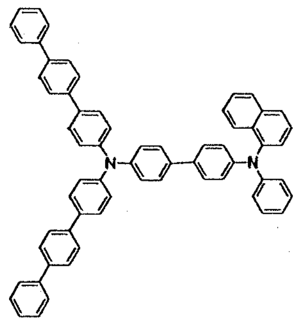

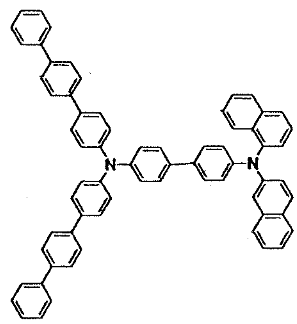

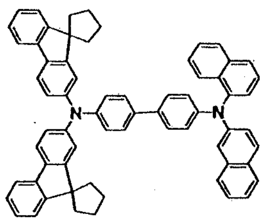

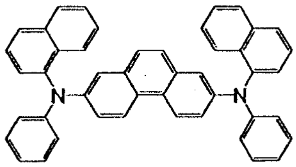

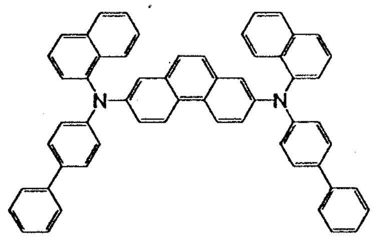

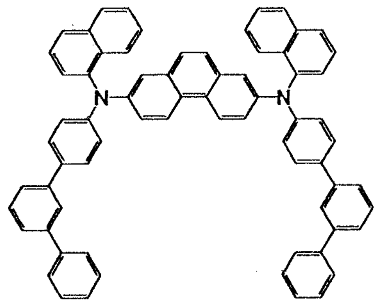

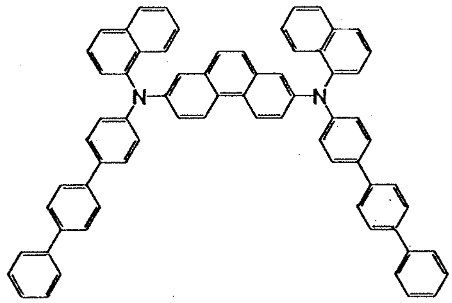

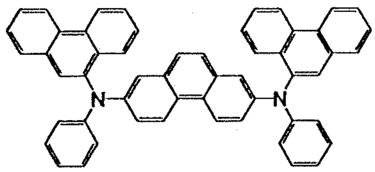

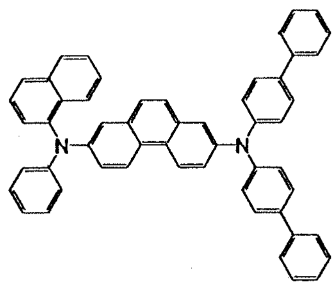

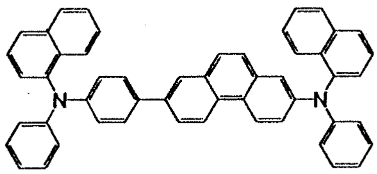

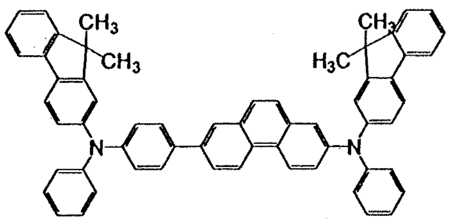

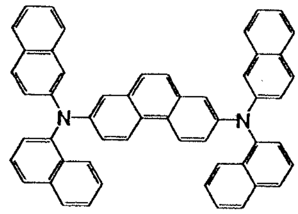

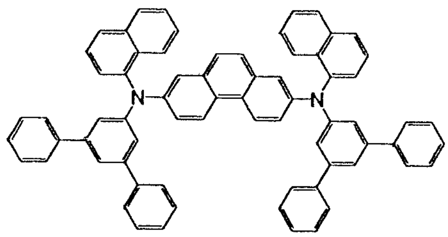

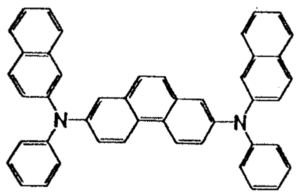

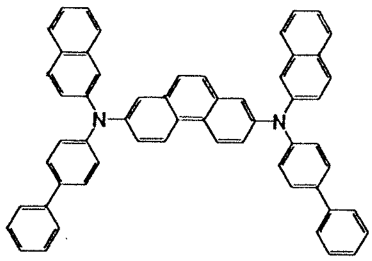

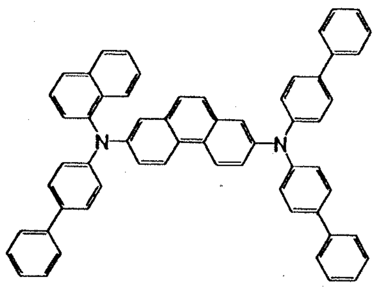

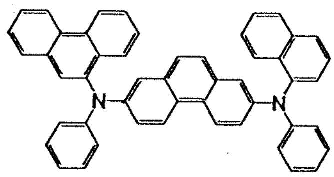

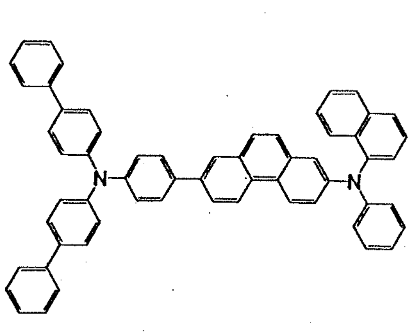

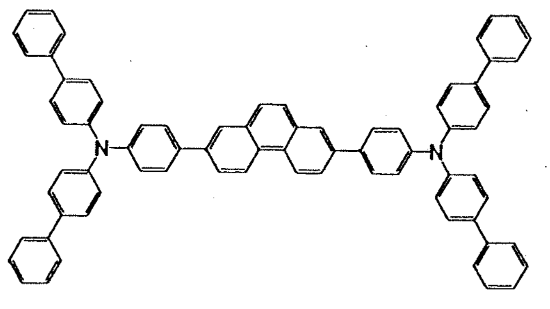

The main compound which forms the second layer is preferably an aromatic amine derivative of the following general formula (4).

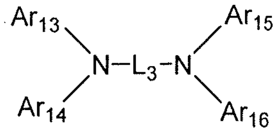

(4)

wherein $L_3$ represents a divalent group selected from a substituted or unsubstituted arylene group having 5 to 60 carbon atoms or a heterocyclic group, $Ar_{13}$ to $Ar_{16}$ independently represent a substituted or unsubstituted substituent having 5 to 50 nucleus atoms; and the substituent of $Ar_{13}$ to $Ar_{16}$ is a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group.

The divalent group represented by $L_3$. is preferably substituted or unsubstituted fluorene, biphenylene, or terphenylene, and still more preferably biphenylene.

$Ar_{13}$ to $Ar_{16}$ are preferably aryl groups having 6 to 20 carbon atoms. $Ar_{13}$ to $Ar_{16}$ are still more preferably a phenyl group, naphthyl group, biphenyl group, terphenyl group, phenanthryl group, fluorenyl group, or a substituent of the following formula.

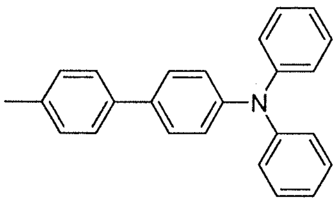
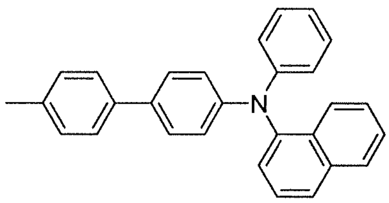
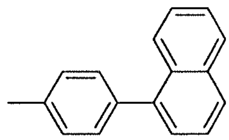

An aromatic amine derivative of the following general formula (5) is also preferably used as the main compound which forms the second layer.

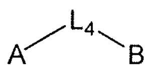

(5)

wherein A is shown by the following general formula (6), and B is shown by the following general formula (7).

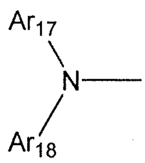

(6)

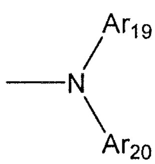

(7)

wherein $Ar_{17}$ to $Ar_{20}$ independently represent substituted or unsubstituted substituents having 5 to 50 nucleus atoms, provided that A and B are not the same, and
$L_4$ represents a divalent group of a substituted or unsubstituted arylene group having 5 to 60 carbon atoms or a heterocyclic group.

The divalent group represented by $L_4$ is preferably biphenylene or terphenylene, and still more preferably biphenylene.
$Ar_{17}$ to $Ar_{20}$ are preferably aryl groups having 6 to 20 carbon atoms. $Ar_{17}$ to $Ar_{20}$ are more preferably a phenyl group, naphthyl group, biphenyl group, terphenyl group, or a substituent of the following formula.

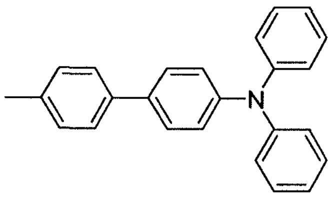
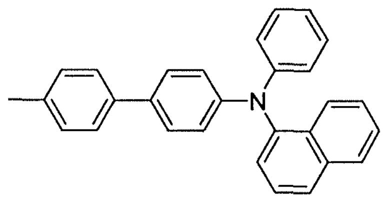
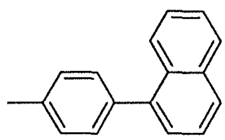

$Ar_{17}$ to $Ar_{20}$ are still more preferably a phenyl group, a naphthyl group, or a biphenyl group.

An aromatic amine of the following general formula (8) is also preferably used as the main compound which forms the second layer.

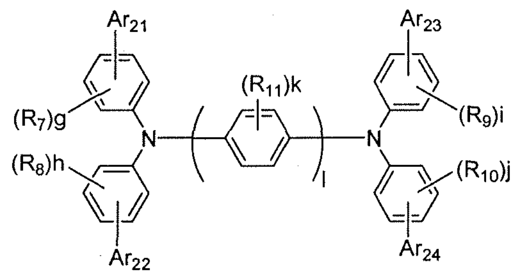
(8)

wherein $R_7$ to $R_{11}$ independently represent hydrogen, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; g, h, i, and j independently represent an integer of 0 to 4; k represents an integer of 0 to 4; 1 represents an integer of 1 to 3; provided that $R_7$ to $R_{11}$ may be bonded to form a saturated or unsaturated substituted or unsubstituted five-membered or six-membered ring structure; and $Ar_{21}$ to $Ar_{24}$ independently represent a substituted or unsubstituted substituent having 5 to 50 nucleus atoms.
In the general formula (8), when g, h, i, and j are respectively two or more, $R_7$s to $R_{11}$s may be respectively the same or different.

$R_7$ to $R_{11}$ are preferably hydrogen or an alkyl group having 1 to 4 carbon atoms. $R_7$ to $R_{11}$ are still more preferably hydrogen.
g, h, i, and j are preferably independently 0 or 1. g, h, i, and j are still more preferably 0.
k is preferably 0 or 1. k is still more preferably 0.
1 is preferably 2 or 3. 1 is still more preferably 2.
$Ar_{21}$ to $Ar_{24}$ are preferably aryl groups having 6 to 20 carbon atoms. $Ar_{21}$ to $Ar_{24}$ are more preferably a phenyl group, a biphenyl group, or a naphthyl group, and still more preferably a phenyl group or a naphthyl group.

An aromatic amine derivative of the following general formula (9) is also preferably used as the main compound which forms the second layer.

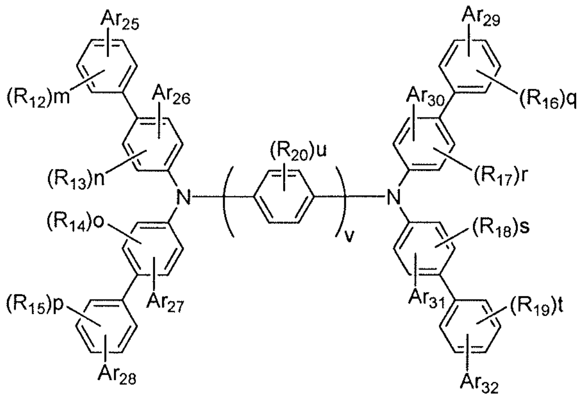

(9)

wherein $R_{12}$ to $R_{20}$ independently represent a hydrogen atom, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; m, p, q, and t independently represent an integer of 0 to 4; n, o, r, s, and u independently represent an integer of 0 to 3; v represents an integer of 1 to 3; provided that $R_{12}$ to $R_{20}$ may be bonded to form a saturated or unsaturated substituted or unsubstituted five-membered or six-membered ring structure; and $Ar_{25}$ to $Ar_{32}$ independently represent a substituted or unsubstituted substituent having 5 to 50 nucleus atoms.
In the general formula (9), when m, p, q, and t are plural numbers, $R_{12}$s to $R_{20}$s may be respectively the same or different.

$R_{12}$ to $R_{20}$ are preferably hydrogen or an alkyl group having 1 to 4 carbon atoms, and still more preferably hydrogen.
m, p, q, and t are preferably independently 0 or 1, and still more preferably 0.
n, o, r, s, and u are preferably independently 0 or 1, and still more preferably 0.
v is preferably 2 or 3, and still more preferably 2.
$Ar_{25}$ to $Ar_{32}$ are preferably aryl groups having 6 to 20 carbon atoms, and still more preferably phenyl groups.

Specific examples of the aromatic amine derivative which forms the second layer are given below.

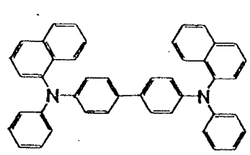

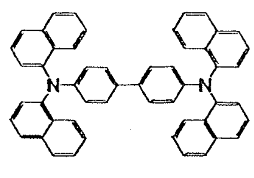

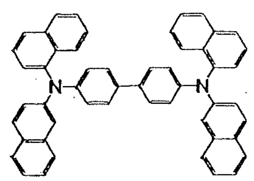

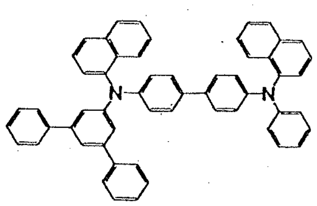

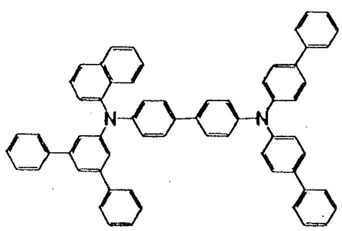

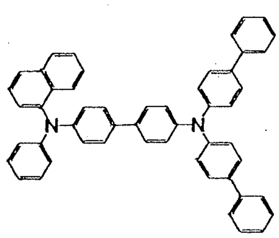

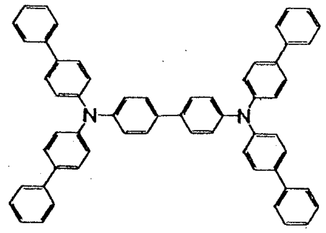

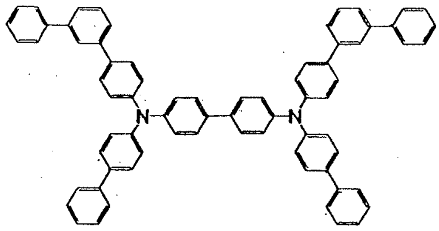

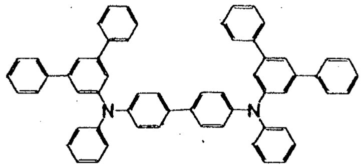

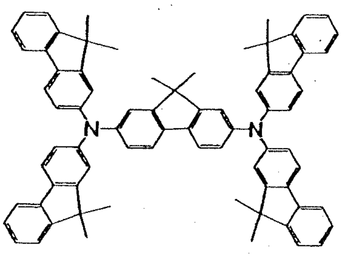

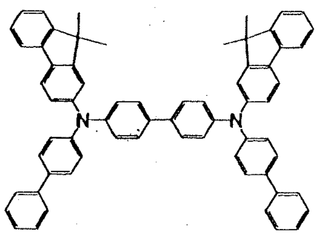

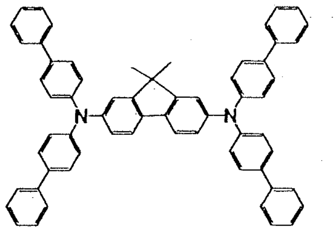

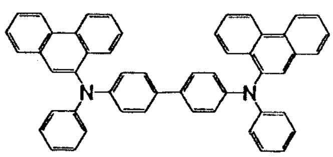

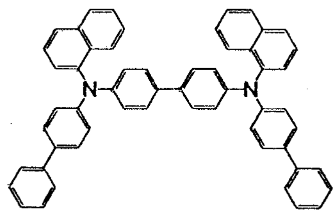

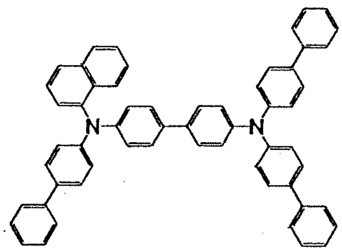

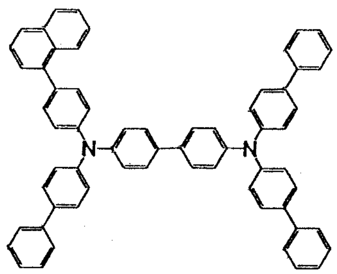

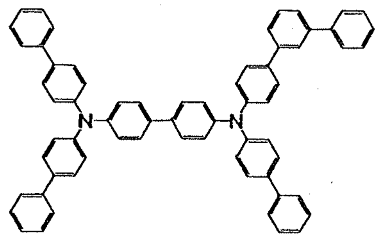

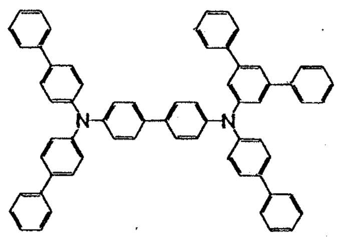

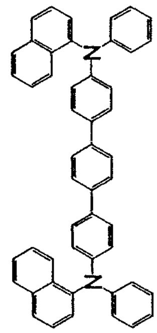

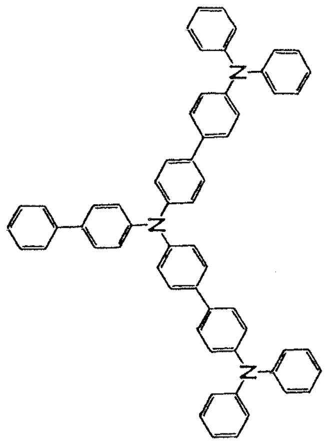

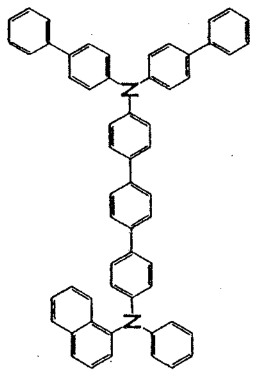

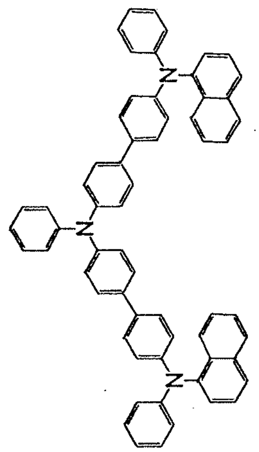

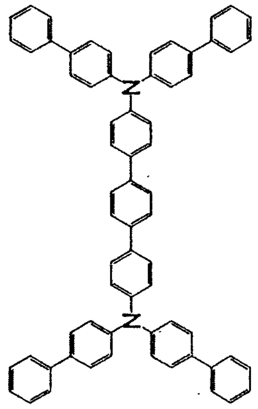

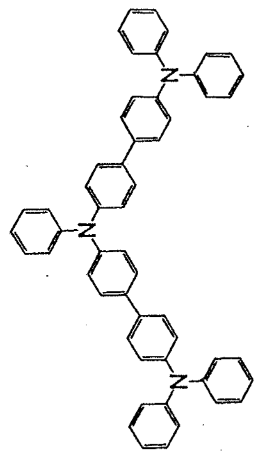

The thickness of the first layer is usually 40 to 1000 nm, and preferably 60 to 200 nm.
The thickness of the second layer is usually 2 to 60 nm, and preferably 4 to 30 nm.
The main compound which forms the first layer has an ionization potential lower than the ionization potential of the main compound which forms the second layer. This facilitates transport of holes from the anode to the first layer and transport of holes from the first layer to the second layer.
The main compound which forms the second layer has a singlet energy gap of preferably 3.0 to 3.8 eV. It is preferable that the main compound which forms the second layer have a singlet energy gap greater than the singlet energy gap of the main compound which forms the first layer. This allows electrons from the cathode to be blocked by the second layer to prevent the electrons from being transported to the first layer.
The main compound which forms the second layer has a triplet energy gap of usually 2.5 eV or more, and preferably 2.8 eV or more.
It is preferable to use an arylamine compound and/or a styrylamine compound as the compound which forms the emitting layer.
The organic EL device according to the invention preferably emits blue light.

EXAMPLES

The invention is described below in more detail by way of examples.
Compounds of the following formulas were synthesized. The characteristics of these compounds were measured using the following methods.
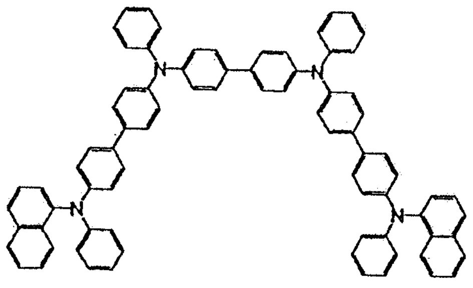

Compound H1

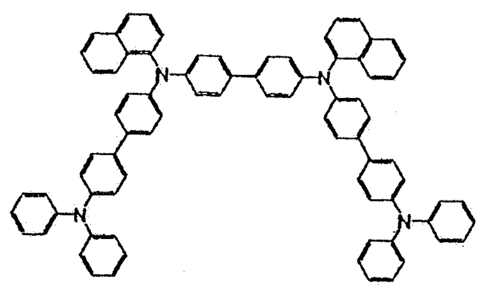

Compound H2

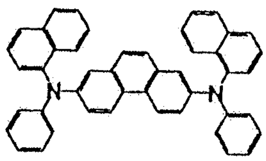

Compound H3

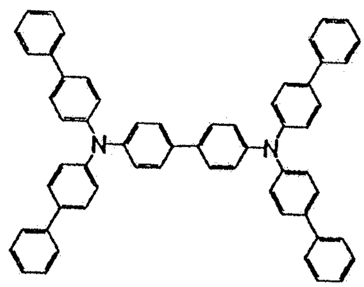

Compound H4

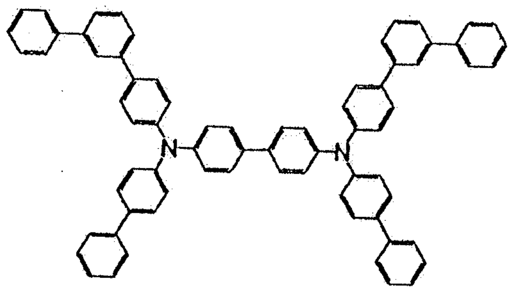

Compound H5

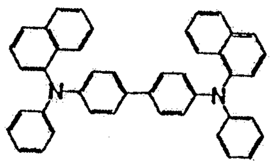

Compound H6

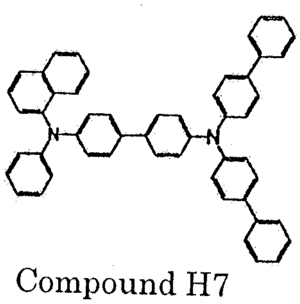

Compound H7

(1) Hole mobility

The hole mobility was measured using a time of flight measuring device "TOF-401" manufactured by Sumitomo Heavy Industries Advanced Machinery Co., Ltd. A semitransparent metal electrode (Al; thickness: 10 nm) was used as a positive electrode, and a transparent oxide electrode (ITO; thickness: 130 nm) was used as a negative electrode. A mobility measurement sample was stacked to a thickness of three μm, and a thin film of a material with a high hole generation capability (copper phthalocyanine; thickness: 50 nm) was stacked on the side of the positive electrode. The ITO substrate used as the negative electrode was washed in the same manner as in Example 1. Each material was stacked by deposition in the same manner as in Example 1.
The sample was placed in a sample chamber of the time of flight measuring device "TOF-401", and the positive electrode and the negative electrode were connected using a gold-plated probe. A signal current was detected by measuring the terminal voltage of load resistors connected in parallel using an oscilloscope.
The signal current is observed when applying laser light. In this case, the current clearly decreases after a certain period of time. This indicates that a sheet of holes has reached the negative electrode. The time at which the current changes (transport time) is referred to as $t_T$. The hole mobility is defined by the following expression.

$$\mu = d/t_T \times E$$

In the above expression, d is the thickness of the sample, and E is the electric field intensity.
In general, the hole mobility varies depending on the electric field intensity. The mobility plotted with respect to the square root of the electric field intensity generally becomes linear. Therefore, when defining the hole mobility as a numerical value, it is necessary to indicate the electric field intensity when the hole mobility is measured.
In this specification, the value at an electric field intensity of $2.5\times10^4$ (V/cm) was used as the mobility ($cm^2/Vs$).

(2) Ionization potential (Ip)

The ionization potential may be measured by applying light (excitation light) from a deuterium lamp to a material through a monochromator, measuring the resulting photoelectric emission using an electrometer, and calculating the photoelectric emission threshold from the resulting photoelectric emission photon energy curve using an extrapolation method, for example.
In more detail, a glass substrate was subjected to ultrasonic cleaning for five minutes in isopropyl alcohol, five minutes in water, and five minutes in isopropyl alcohol, and then subjected to UV cleaning for 30 minutes. A film was formed using a vacuum deposition device to obtain a thin film sample of the measurement target substance. The film was formed to a thickness of 2000 angstroms using "SGC-8MII" manufactured by Showa Shinku Co., Ltd. at a final vacuum of $5.3\times10^{-4}$ Pa or less and a deposition rate of 2 angstroms/sec.
The ionization potential was measured using an atmospheric photoelectron spectrometer ("AC-1" manufactured by Riken Keiki Co., Ltd.). Light obtained by dispersing ultraviolet rays from a deuterium lamp using a spectroscope was applied to the thin film sample, and the emitted photoelectrons were measured using an open counter.
When the ionization potential was 6.0 eV or less, the intersection of the background and the square root of the quantum yield in the photoelectron spectrum in which the square root of the quantum yield was plotted along the vertical axis and the energy of applied light was plotted along the horizontal axis (measured at an interval $\Delta$ of 0.05 eV) was taken as the ionization potential.
When the ionization potential was greater than 6.0 eV, the ionization potential was determined by converting the HOMO level obtained by ultraviolet photoelectron spectroscopy (UPS) measurement.

(3) Singlet energy level ($Eg^S$)

The compound was dissolved in toluene to obtain a $10^{-5}$ mol/l solution. The absorption spectrum was measured using a spectro-photometer ("U3410" manufactured by Hitachi, Ltd.). A tangent line to the UV absorption spectrum was drawn at the rising edge on the longer wavelength side, and the wavelength (absorption edge) at which the tangent line intersects the horizontal axis was determined. This wavelength was converted into an energy value to determine the singlet energy level.

(4) Triplet energy level ($Eg^T$)

The lowest excited triplet energy level $Eg^T$ was measured as follows. The lowest excited triplet energy level $Eg^T$ was measured using a Fluorolog II manufactured by SPEX at a concentration of 10 micromol/l and a temperature of 77 K using EPA (diethyl ether: isopentane: isopropyl alcohol = 5:5:2 (volume ratio)) as a solvent utilizing a quartz cell. A tangent line to the resulting phosphorescence spectrum was drawn at the rising edge on the shorter wavelength side, and the wavelength (emission edge) at which the tangent line intersects the horizontal axis was determined. This wavelength was converted into an energy value.

Synthesis Example 1 (synthesis of intermediate 1)

1058 g of N,N-diphenylamine (manufactured by Tokyo Kasei Kogyo Co., Ltd.), 2542 g of 4,4'-diiodobiphenyl (manufactured by Wako Pure Chemical Industries, Ltd.), 1296 g of potassium carbonate (manufactured by Wako Pure Chemical Industries, Ltd.), 39.8 g of copper powder (manufactured by Wako Pure Chemical Industries, Ltd.), and 4 l of decalin (manufactured by Wako Pure Chemical Industries, Ltd.) were allowed to react at 200°C for six days in an argon stream. After the reaction, the resulting liquid was filtered, and insoluble components were washed with toluene. After adding the filtrate to the resulting product, the mixture was concentrated. After the addition of 3 l of toluene to the residue, precipitated crystals were filtered out, and the filtrate was concentrated. After the addition of 10 l of methanol to the residue, the mixture was stirred, and the supernatant liquid was removed. After the addition of 3 l of methanol, the mixture

was stirred, and the supernatant liquid was removed. The resulting product was purified by column chromatography to obtain a yellow powder. The powder was dissolved in 1.5 l of toluene with heating. After the addition of 1.5 l of hexane, the mixture was cooled. Then, precipitated crystals were filtered out to obtain 1343 g of an intermediate 1 of the following formula. As a result of FD-MS analysis, a main peak of m/z=447 was obtained for $C_{24}H_{18}IN$=447. Therefore, the resulting product was identified as the intermediate 1 of the following formula.

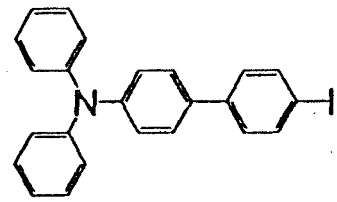

Synthesis Example 2 (synthesis of intermediate 2)

1371 g of N-phenyl-1-naphthylamine (manufactured by Kanto Chemical Co., Inc.), 2542 g of 4,4'-diiodobiphenyl (manufactured by Wako Pure Chemical Industries, Ltd.), 1296 g of potassium carbonate (manufactured by Wako Pure Chemical Industries, Ltd.), 39.8 g of copper powder (manufactured by Wako Pure Chemical Industries, Ltd.), and 4 l of decalin (manufactured by Wako Pure Chemical Industries, Ltd.) were allowed to react at 200°C for six days in an argon stream. After the reaction, the resulting liquid was filtered, and insoluble components were washed with toluene. After adding the filtrate to the resulting product, the mixture was concentrated. After the addition of 3 l of toluene to the residue, precipitated crystals were filtered out, and the filtrate was concentrated. After the addition of 10 l of methanol to the residue, the mixture was stirred, and the supernatant liquid was removed. After the addition of 3 l of methanol, the mixture was stirred, and the supernatant liquid was removed. The resulting product was purified by column chromatography to obtain a yellow powder. The powder was dissolved in 1.5 l of toluene with heating. After the addition of 1.5 l of hexane the mixture was cooled. Then, precipitated crystals were filtered out to obtain 640 g of an intermediate 2 of the following formula. As a result of FD-MS analysis, a main peak of m/z=497 was obtained for $C_{28}H_{20}IN$=497. Therefore, the resulting product was identified as the intermediate 2 of the following formula.

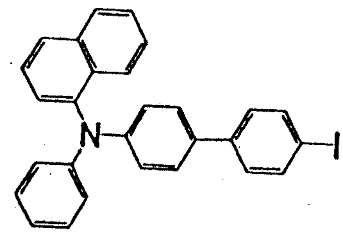

Synthesis Example 3 (synthesis of intermediate 3)

547 g of 1-acetamidonaphthalene (manufactured by Tokyo Kasei Kogyo Co., Ltd.), 400 g of 4,4'-diiodobiphenyl (manufactured by Wako Pure Chemical Industries, Ltd.), 544 g of potassium carbonate (manufactured by Wako Pure Chemical Industries, Ltd.), 12.5 g of copper powder (manufactured by Wako Pure Chemical Industries, Ltd.), and 2 l of decalin (manufactured by Wako Pure Chemical Industries, Ltd.) were allowed to react at 190°C for four days in an argon stream. After the reaction, the resulting liquid was cooled. After the addition of 2 l of toluene, insoluble components were filtered off. These filtered components were dissolved in 4.5 l of chloroform. After removing insoluble components, the residue was subjected to activated carbon treatment and concentrated. After the addition of 3 l of acetone to the concentrate, 382 g of precipitated crystals were filtered off. The crystals were suspended in 5 l of ethylene glycol (manufactured by Wako Pure Chemical Industries, Ltd.) and 50 ml of water. After the addition of 145 g of an 85% potassium hydroxide aqueous solution, the mixture was allowed to react at 120°C for two hours. After the reaction, the reaction liquid was poured into 10 l of water. Precipitated crystals were filtered off and washed with water and methanol. The resulting crystals were dissolved in 3L of tetrahydrofuran with heating. The mixture was subjected to activated carbon treatment and concentrated. Acetone was added to the concentrate to precipitate crystals. The precipitated crystals were filtered off to obtain 292 g of an intermediate 3 of the following formula. As a result of FD-MS analysis, a main peak of m/z=436 was obtained for $C_{32}H_{24}N_2$=436. Therefore, the resulting product was identified as the intermediate 3 of the

following formula.

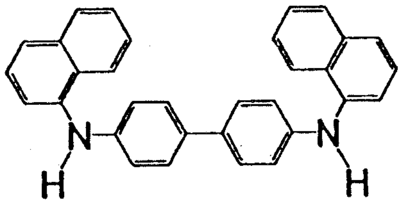

Synthesis Example 4 (synthesis of intermediate 4)

A 200 ml three-necked flask was charged with 20.0 g of 4-bromobiphenyl (manufactured by Tokyo Kasei Kogyo Co., Ltd.), 8.64 g of t-butoxysodium (manufactured by Wako Pure Chemical Industries, Ltd.), and 84 mg of palladium acetate (manufactured by Wako Pure Chemical Industries, Ltd.). A stirring rod was placed in the flask. The necks of the flask excluding middle neck were provided with rubber caps. The middle neck was provided with a reflux coil, and a three-way stopcock and a balloon filled with argon gas were provided over the reflux coil. The atmosphere inside the system was substituted for the argon gas from the balloon three times using a vacuum pump. After the addition of 120 ml of dehydrated toluene (manufactured by Hiroshima Wako Co., Ltd.), 4.08 ml of benzylamine (manufactured by Tokyo Kasei Kogyo Co., Ltd.), and 338 microliters of tris-t-butylphosphine (manufactured by Aldrich; 2.22 mol/L toluene solution) using a syringe through a rubber septum, the mixture was stirred at room temperature for five minutes.

The flask was then placed in an oil bath, and the solution was gradually heated to 120°C with stirring. After seven hours, the reaction was terminated by removing the flask from the oil bath. The reaction solution was then allowed to stand for 12 hours in an argon atmosphere. The reaction solution was then poured into a separating funnel, and 600 ml of dichloromethane was added to dissolve the precipitate. After washing with 120 ml of a saturated sodium chloride solution, the organic layer was dried over anhydrous potassium carbonate. The solvent of the organic layer obtained by filtering out the potassium carbonate was evaporated. After the addition of 400 ml of toluene and 80 ml of ethanol to the residue, the mixture was heated to 80°C using a drying tube to completely dissolve the residue. The mixture was then allowed to stand for 12 hours at room temperature to effect recrystallization. The precipitated crystals were filtered off and dried at 60°C under vacuum to obtain 13.5 g of N,N-di-(4-biphenylyl)-benzylamine.

A 300 ml single-necked flask was charged with 1.35 g of N,N-di-(4-biphenylyl)-benzylamine and 135 mg of palladium-activated carbon (manufactured by Hiroshima Wako Co., Ltd.; palladium content: 10 wt%). After the addition of 100 ml of chloroform and 20 ml of ethanol, the components were dissolved. A stirring rod was placed in the flask. The flask was provided with a three-way stopcock equipped with a balloon filled with 2 l of hydrogen gas. The atmosphere inside the flask was then substituted for the hydrogen gas ten times using a vacuum pump. After supplying hydrogen gas to the balloon so that the balloon contained 2 l of hydrogen gas, the solution was vigorously stirred at room temperature. After stirring the solution for 30 hours, 100 ml of dichloromethane was added to the solution, and the catalyst was filtered out. The resulting solution was poured into a separating funnel and washed with 50 ml of a saturated sodium hydrogen carbonate solution. The organic layer was then separated and dried over anhydrous potassium carbonate. After filtration, the solvent was evaporated. 50 ml of toluene was added to the residue to effect recrystallization. The precipitated crystals were filtered off and dried at 50°C under vacuum to obtain 0.99 g of di-4-biphenylylamine (intermediate 4) of the following formula. As a result of FD-MS analysis, a main peak of m/z=321 was obtained for $C_{24}H_{19}N$=321. Therefore, the resulting product was identified as the intermediate 4 of the following formula.

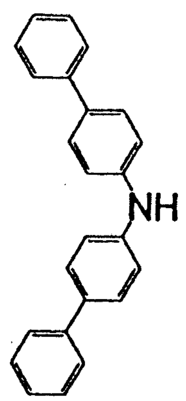

Synthesis Example 5 (synthesis of intermediate 5)

A three-necked flask was charged with 250 g of m-terphenyl (manufactured by Aldrich), 50 g of hydroiodic acid dihydrate, 75 g of iodine, 750 ml of acetic acid, and 25 ml of concentrated sulfuric acid. The mixture was allowed to react at 70°C for three hours. After the reaction, the resulting solution was poured into 5 l of methanol. The mixture was then stirred for one hour. The resulting crystals were filtered off, purified by column chromatography, and recrystallized from acetonitrile to obtain 64 g 3'-phenyl-4-iodobiphenyl.

A 200 ml three-necked flask was charged with 5.7 g of benzamide (manufactured by Tokyo Kasei Kogyo Co., Ltd.), 10 g of 4-bromobiphenyl (manufactured by Tokyo Kasei Kogyo Co., Ltd.), 0.82 g of copper (I) iodide (manufactured by Wako Pure Chemical Industries, Ltd.), 0.76 g of N,N'-dimethylethylenediamine (manufactured by Aldrich), 11.8 g of potassium carbonate (manufactured by Wako Pure Chemical Industries, Ltd.), and 60 ml of xylene. The mixture was allowed to react at 130°C for 36 hours in an argon stream. The resulting solution was cooled, filtered, and washed with toluene. The resulting solution was washed with water and methanol and dried to obtain 10.5 g of benzamide-4-biphenyl as a light yellow powder.

A 300 ml three-necked flask was charged with 16.4 g of benzamide-4-biphenyl, 25.6 g of 3'-phenyl-4-iodobiphenyl, 1.14 g of copper (I) iodide (manufactured by Wako Pure Chemical Industries, Ltd.), 1.06 g of N,N'-dimethylethylenediamine (manufactured by Aldrich), 20.0 g of potassium carbonate (manufactured by Wako Pure Chemical Industries, Ltd.), and 100 ml of xylene. The mixture was allowed to react at 130°C for 36 hours in an argon stream. The resulting solution was cooled, filtered, and washed with toluene. The resulting solution was washed with water and methanol and dried to obtain 14.0 g of a light yellow powder. A 300 ml three-necked flask was charged with 14.0 g of the above powder, 15.1 g of potassium hydroxide (manufactured by Wako Pure Chemical Industries, Ltd.), 13 ml of ion-exchanged water, 17 ml of xylene(manufactured by Wako Pure Chemical Industries, Ltd.), and 9 ml of EtOH (manufactured by Wako Pure Chemical Industries, Ltd.). The mixture was refluxed for 36 hours. After the reaction, the resulting product was extracted with toluene and dried over magnesium sulfate. The dried product was concentrated under reduced pressure, and the resulting crude product was purified by column chromatography. The product was recrystallized from toluene, filtered off, and dried to obtain 9.3 g of an intermediate 5 of the following formula as a white powder. As a result of FD-MS analysis, a main peak of m/z=397 was obtained for $C_{30}H_{23}N$=397. Therefore, the resulting product was identified as the intermediate 5 of the following formula.

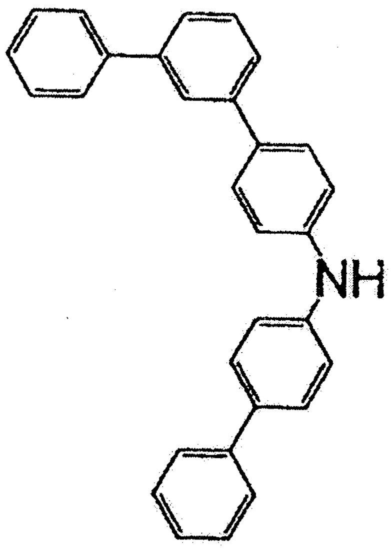

Synthesis Example 6 (synthesis of intermediate 6)

30.0 g of 9,10-dihydrophenanthrene was dissolved in 200 ml of $(MeO)_3PO$. 100 ml of a $(MeO)_3PO$ solution of 56.7 g of bromine was then added dropwise to the solution. The reaction solution was stirred for eight hours while shielding the flask from light. As a result, a white precipitate was produced. After the reaction, the white precipitate was filtered off from the reaction solution. The resulting crystals were washed with methanol and dried under vacuum to obtain 32.7 g of 2,7-dibromo-9,10-dihydrophenanthrene as a white crystal. 32.7 g of 2, 7-dibromo-9, 10-dihydrophenanthrene, 24. l g of DDQ, and 500 ml of benzene were refluxed with heating for 64 hours in an argon atmosphere. After the reaction, the solution was cooled to room temperature and filtered. The filtrate was concentrated using an evaporator, and the residue was washed with methanol. The resulting solid was purified by short column chromatography and rerecrystallized from toluene to obtain 15. 5 g of 2,7-dibromophenanthrene (intermediate 6) of the following formula as a colorless needle-like crystal. As a result of FD-MS analysis, a main peak of m/z=336 was obtained for $C_{14}H_8Br_2$=336. Therefore, the resulting product was identified as the intermediate 6 of the following formula.

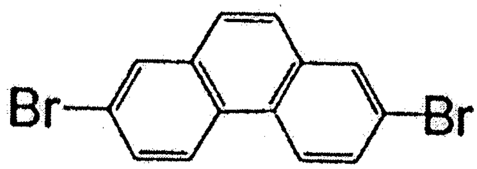

Synthesis Example 7 (synthesis of compound H1)

3.4 g of N,N'-diphenylbenzidine (manufactured by Tokyo Kasei Kogyo Co., Ltd.), 10.0 g of the intermediate 2, 4.0 g of t-butoxysodium (manufactured by Hiroshima Wako Co., Ltd.), 0.66 g of bis(triphenylphosphine)palladium (II) chloride (manufactured by Tokyo Kasei Kogyo Co., Ltd.), and 300 ml of xylene were allowed to react at 130°C for 24 hours in an argon stream. After cooling the reaction solution, 500 ml of water was added. After filtering the mixture through celite, the filtrate was extracted with toluene and dried over anhydrous magnesium sulfate. The dried product was concentrated under reduced pressure. The resulting crude product was purified by column chromatography, recrystallized from toluene, filtered off, and dried to obtain 8.2 g of a light yellow powder. As a result of FD-MS analysis, a main peak of m/z=1074 was obtained for $C_{80}H_{58}N_4$=1074. Therefore, the resulting product was identified as a compound H1 (Ip=5.23 eV, $Eg^S$=3.05 eV) of the following formula. The hole mobility was $1.2 \times 10^{-3}$ ($cm^2/Vs$).

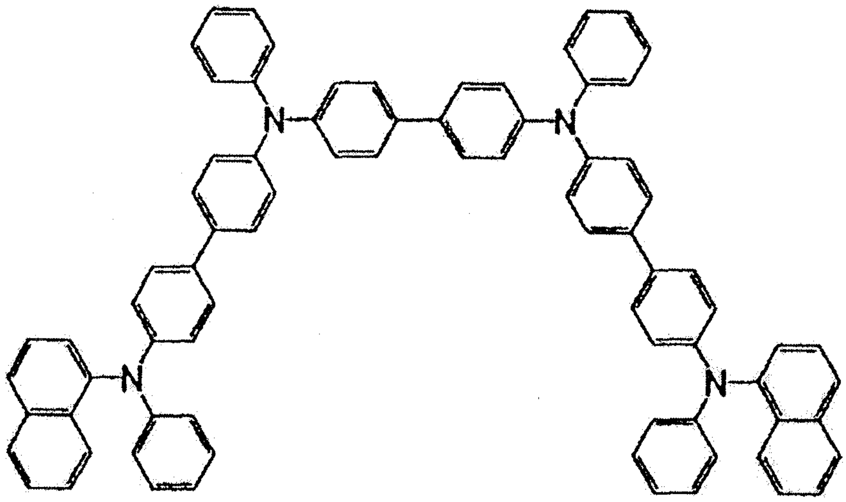

Synthesis Example 8 (synthesis of compound H2)

The reaction was carried out in the same manner as in Synthesis Example 7 except for using 4.4 g of the intermediate 3 instead of 3.4 g of N,N'-diphenylbenzidine and using 9.0 g of the intermediate 1 instead of 10.0 g of the intermediate 2 to obtain 7.5 g of a light yellow powder. As a result of FD-MS analysis, a main peak of m/z=1074 was obtained for $C_{80}H_{58}N_4$=1074. Therefore, the resulting product was identified as a compound H2 (Ip=5.22 eV, $Eg^S$=3.05 eV) of the following formula. The hole mobility was $1.4\times10^{-3}$ ($cm^2$/Vs).

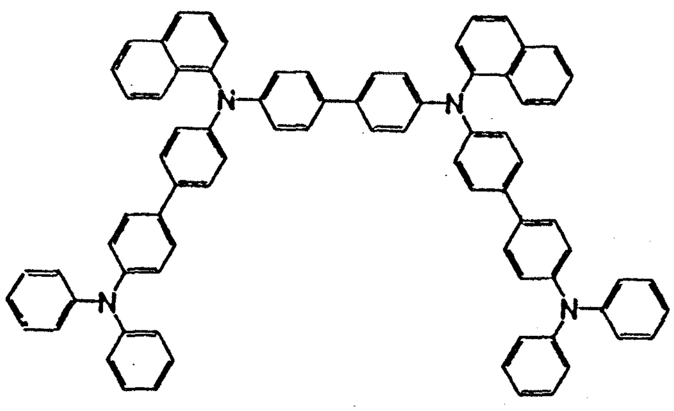

Synthesis Example 9 (synthesis of compound H3)

The reaction was carried out in the same manner as in Synthesis Example 7 except for using 3.4 g of the intermediate 6 instead of 3.4 g of N,N'-diphenylbenzidine and using 4.4 g of 1-naphthylphenylamine (manufactured by Tokyo Kasei Kogyo Co., Ltd.) instead of 10.0 g of the intermediate 2 to obtain 7.5 g of a light yellow powder. As a result of FD-MS analysis, a main peak of m/z=612 was obtained for $C_{46}H_{32}N_2$=588. Therefore, the resulting product was identified as a compound H3 (Ip=5.29 eV, $Eg^S$=3.06 eV) of the following formula. The hole mobility was $9.0\times10^{-4}$ ($cm^2$/Vs).

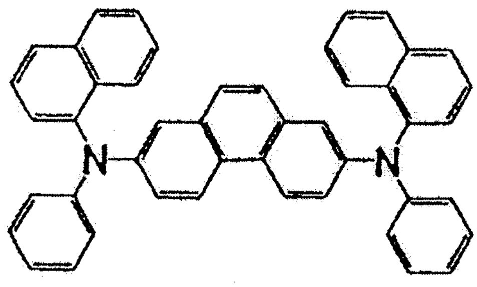

Synthesis Example 10 (synthesis of compound H4)

The reaction was carried out in the same manner as in Synthesis Example 7 except for using 4.1 g of 4, 4' -diiodobiphenyl instead of 3.4 g of N,N'-diphenylbenzidine and using 6.5 g of the intermediate 4 instead of 10.0 g of the intermediate 2 to obtain 5.2 g of a light yellow powder. As a result of FD-MS analysis, a main peak of m/z=792 was obtained for $C_{60}H_{44}N_2$=792. Therefore, the resulting product was identified as a compound H4 (Ip=5.46 eV, $Eg^S$=3.09 eV, $Eg^T$=2.54 eV) of the following formula. The hole mobility was $8.2\times10^{-4}$ ($cm^2$/Vs).

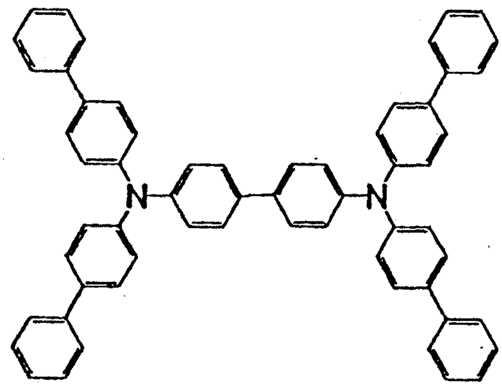

Synthesis Example 11 (synthesis of compound H5)

The reaction was carried out in the same manner as in Synthesis Example 10 except for using 8.0 g of the intermediate 5 instead of 6.5 g of the intermediate 4 to obtain 6.7 g of a light yellow powder. As a result of FD-MS analysis, a main peak of m/z=944 was obtained for $C_{72}H_{52}N_2$=944. Therefore, the resulting product was identified as a compound H5 (Ip=5.42 eV, $Eg^S$=3.09 eV) of the following formula. The hole mobility was $4.8\text{x}10^{-4}$ ($cm^2$/Vs).

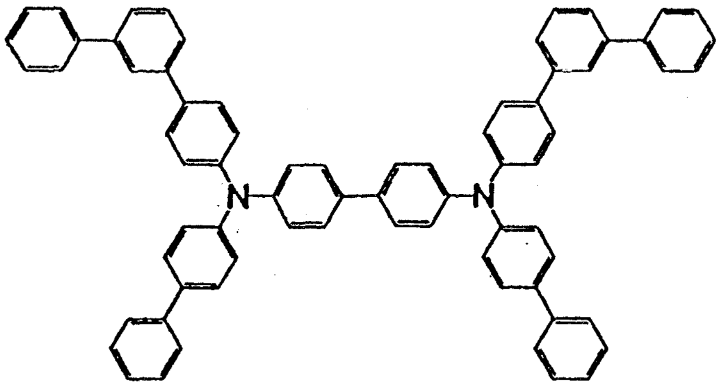

Synthesis Example 12 (synthesis of compound H6)

The reaction was carried out in the same manner as in Synthesis Example 10 except for using 4.4 g of 1-naphthylphenylamine(manufactured by Tokyo Kasei Kogyo Co., Ltd.) instead of 6.5 g of the intermediate 4 to obtain 3.9 g of a light yellow powder. As a result of FD-MS analysis, a main peak of m/z=588 was obtained for $C_{44}H_{32}N_2$=588. Therefore, the resulting product was identified as a compound H6 (Ip=5.36 eV, $Eg^S$=3.08 eV, $Eg^T$=2.46 eV) of the following formula. The hole mobility was $5.9\times10^{-4}$ ($cm^2$/Vs).

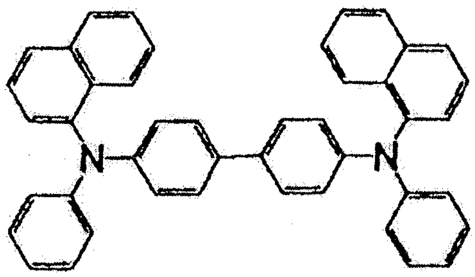

Synthesis Example 13 (synthesis of compound H7)

The reaction was carried out in the same manner as in Synthesis Example 10 except for using 5.0 g of the intermediate 2 instead of 4.1 g of 4,4'-diiodobiphenyl and using 3.2 g of the intermediate 4 to obtain 4.3 g of a light yellow powder. As a result of FD-MS analysis, a main peak of m/z=690 was obtained for $C_{52}H_{38}N_2$=690. Therefore, the resulting product was identified as a compound H7 (Ip=5.33 eV, $Eg^S$=3.11 eV) of the following formula. The hole mobility was $7.6\times10^{-4}$ ($cm^2$/Vs).

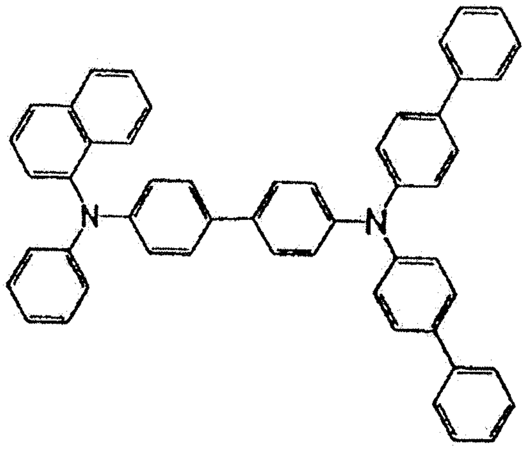

Example 1 (fabrication of organic EL device)

A glass substrate with an ITO (indium tin oxide) transparent electrode (25×75×1.1 mm) (manufactured by Geomatics) was subjected to ultrasonic cleaning for five minutes in isopropyl alcohol, and then subjected to UV ozone cleaning for 30 minutes.
The cleaned glass substrate with the linear transparent electrode was installed in a substrate holder of a vacuum deposition device, and a film of the compound H2 with a thickness of 60 nm was formed on the surface of the glass substrate on which the linear transparent electrode was formed so that the transparent electrode was covered. The H2 film functions as a hole injection layer. A layer of the compound H4 with a thickness of 20 nm was formed on the H2 film as a hole transporting material. This film functions as a hole transporting layer. A compound EM1 of the following formula was deposited to a thickness of 40 nm. An amine compound D1 of the following formula having a styryl group was deposited as a luminescent molecule so that the weight ratio of the compound EM1 and the compound D1 was 40:2. This film functions as an emitting layer.
An Alq film of the following formula was formed on this film to a thickness of 10 nm. This film functions as an electron injecting layer. Li (reducing dopant) (Li source: manufactured by SAES getters) and Alq were then simultaneously deposited to form an Alq:Li film (thickness: 10 nm) as an electron injecting layer (cathode). Al was deposited on the Alq:Li film to form a metal cathode to fabricate an organic EL device.
The organic EL device obtained was subjected to measurement of luminous efficiency and voltage and emission color observation. The luminance was measured using "CS1000" manufactured by Minolta, and the luminous efficiency at 10 mA/$cm^2$ was calculated. Table 1 shows the measurement results of the half life during DC constant current drive at room temperature and an initial luminance of 5000 nit. Note that this lifetime measurement is an accelerated test. The half life during normal use (initial luminance: 1000 nit) may be obtained by multiplying the resulting value by 30.
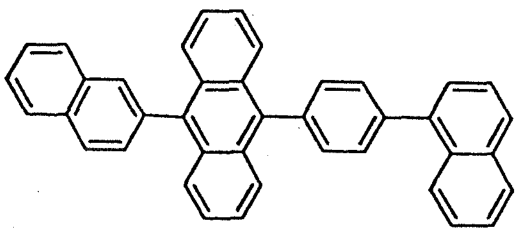

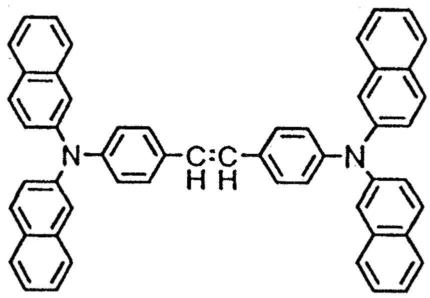

EM1 D1

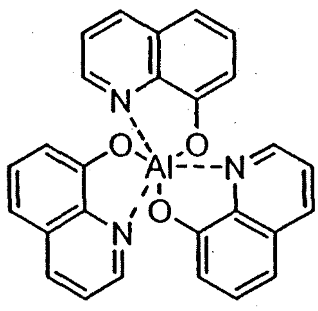

Alq

Examples 2 to 7 (fabrication of organic EL device)

An organic EL device was fabricated in the same manner as in Example 1 except for changing the hole injecting material, the hole transporting material, and the thickness of each material as shown in Table 1.
The results for the organic EL device obtained are shown in Table 1.

Comparative Example 1

An organic EL device was fabricated in the same manner as in Example 1 except that the thickness of the hole injecting material was changed to 80 nm and the hole transporting material was not used.
The results for the organic EL device obtained are shown in Table 1.

Comparative Examples 2 to 6

An organic EL device was fabricated in the same manner as in Example 1 except for changing the hole injecting material, the hole transporting material, and the thickness of each material as shown in Table 1. As shown in Table 1, the hole transporting layer was not used in Comparative Examples 1 and 2.
The following compounds were used in Comparative Examples 4 to 6.
The results for the organic EL device obtained are shown in Table 1.
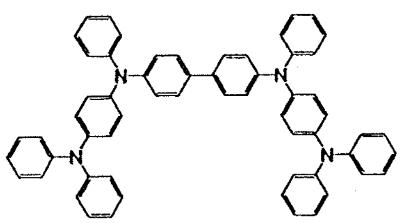

Comparative Compound 1

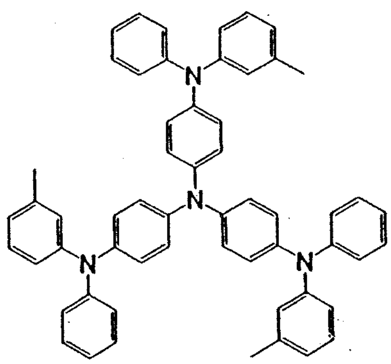

Comparative Compound 2

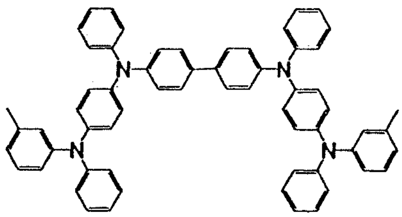

Comparative Compound 3

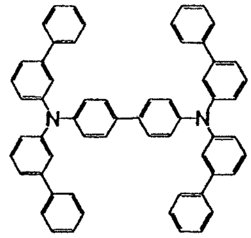

Comparative Compound 4

TABLE 1

| | Hole injecting layer | | | Hole transporting layer | | | | Evaluation results | | | |
|---|---|---|---|---|---|---|---|---|---|---|---|
| | Hole injecting material | Thickness (nm) | Mobility ($10^{-3}$ $cm^2/Vs$ | Hole transporting material | Thickness (nm) | Mobility ($10^{-4}$ $cm^2/Vs$) | Mobility/ thickness ($10^2$ cm/Vs) | Luminous efficiency (cd/A) | Voltage (V) | Emission color | Half life (h) |
| Example 1 | H2 | 60 | 1.4 | H4 | 20 | 8.2 | 4.1 | 5.6 | 5.7 | Blue | 350 |
| Example 2 | H2 | 70 | 1.4 | H4 | 10 | 8.2 | 8.2 | 5.8 | 5.3 | Blue | 370 |
| Example 3 | H2 | 60 | 1.4 | H5 | 10 | 4.8 | 4.8 | 6.2 | 5.6 | Blue | 410 |
| Example 4 | H2 | 75 | 1.4 | H5 | 5 | 4.8 | 9.6 | 6.4 | 5.3 | Blue | 440 |
| Example 5 | H2 | 60 | 1.4 | H7 | 20 | 7.6 | 3.8 | 5.7 | 5.4 | Blue | 370 |
| Example 6 | H1 | 60 | 1.2 | H4 | 20 | 8.2 | 4.1 | 6.2 | 5.6 | Blue | 380 |
| Example 7 | H3 | 60 | 0.90 | H4 | 20 | 8.2 | 4.1 | 5.8 | 5.8 | Blue | 370 |
| Comparative Example 1 | H2 | 80 | 1.4 | - | - | - | - | 3.8 | 7.3 | Blue | 70 |
| Comparative Example 2 | H6 | 80 | 0.59 | - | - | - | - | 3.2 | 7.0 | Blue | 130 |
| Comparative Example 3 | H2 | 60 | 1.4 | H6 | 20 | 5.9 | 2.9 | 5.6 | 6.4 | Blue | 250 |
| Comparative Example 4 | Comparative compound 1 | 60 | 0.51 | H4 | 20 | 8.2 | 4.1 | 5.4 | 6.9 | Blue | 240 |
| Comparative Example 5 | Comparative compound 2 | 60 | 0.076 | H4 | 20 | 8.2 | 4.1 | 5.4 | 7.2 | Blue | 190 |
| Comparative Example 6 | Comparative compound 3 | 60 | 0.46 | Comparative compound 4 | 20 | 2.4 | 1.2 | 5.2 | 7.3 | Blue | 210 |

Example 8 (fabrication of organic EL device)

An organic EL device was fabricated in the same manner as in Example 1 except for using an arylamine compound D2 of the following formula instead of the amine compound D1 having a styryl group.

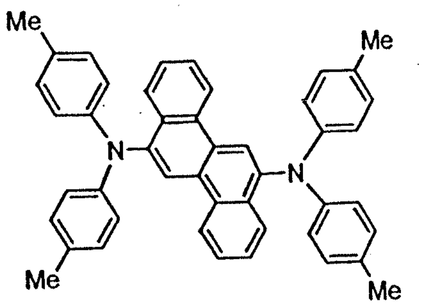

D2

wherein Me indicates a methyl group.
The results for the organic EL device obtained are shown in Table 2.

Comparative Example 7

An organic EL device was fabricated in the same manner as in Example 8 except for using the comparative compound 1 instead of the compound H2 as the hole injecting material.
The results for the organic EL device obtained are shown in Table 2.

TABLE 2

| | Hole injecting layer | | | Hole transporting layer | | | | Evaluation results | | | |
|---|---|---|---|---|---|---|---|---|---|---|---|
| | Hole injecting material | Thickness (nm) | Mobility ($10^{-3}$ $cm^2/Vs$) | Hole transporiting material | Thickness (nm) | Mobility ($10^{-4}$ $cm^2/Vs$) | Mobility/ thickness ($10^2$ cm/Vs) | Luminous efficiency (cd/A) | Voltage (V) | Emission color | Half life (h) |
| Example 8 | H2 | 60 | 1.4 | H4 | 20 | 8.2 | 4.1 | 5.7 | 5.7 | Blue | 360 |
| Comparative Example 7 | comparative compound 1 | 60 | 0.51 | H4 | 20 | 8.2 | 4.1 | 5.4 | 6.8 | Blue | 240 |

INDUSTRIAL APPLICABILITY

The organic EL device according to the invention exhibits high luminous efficiency and long lifetime, may be used as an organic EL material of each color such as blue, may be applied in various fields such as a display element, display, backlight, illumination light source, sign, signboard, and interior, and is particularly suitable as a display element for a color display.

## Claims

1. An organic electroluminescent device comprising,
a cathode, an anode, an emitting layer provided between the cathode and the anode, and
at least a first layer and a second layer stacked between the anode and the emitting layer in this order from the anode side,
the first layer having a hole mobility of 7. $0\times10^{-4}$ ($cm^2/Vs$, electric field intensity: $2.5\times10^4$ (V/cm)) or more,
the second layer having a hole mobility of $7.0\times10^{-4}$ ($cm^2/Vs$, electric field intensity: $2.5\times10^4$ (V/cm)) or more, and
a main compound which forms the first layer differing from a main compound which forms the second layer.

2. An organic electroluminescent device comprising,
a cathode, an anode, an emitting layer provided between the cathode and the anode, and
at least a first layer and a second layer stacked between the anode and the emitting layer in this order from the anode side,
the first layer having a hole mobility of $7.0\times10^{-4}$ ($cm^2/Vs$, electric field intensity: $2.5x10^4$ (V/cm)) or more, the second layer having a hole mobility/thickness relationship of hole mobility $\mu$ ($cm^2/Vs$)/thickness d (nm) > $3.0\times10^2$ (cm/Vs), and a main compound which forms the first layer differing from a main compound which forms the second layer.

3. The organic electroluminescent device according to claim 1 or 2, wherein the main compound which forms the first layer is an aromatic amine derivative.

4. The organic electroluminescent device according to claim 3, wherein the aromatic amine derivative is a compound of the following general formula (1),

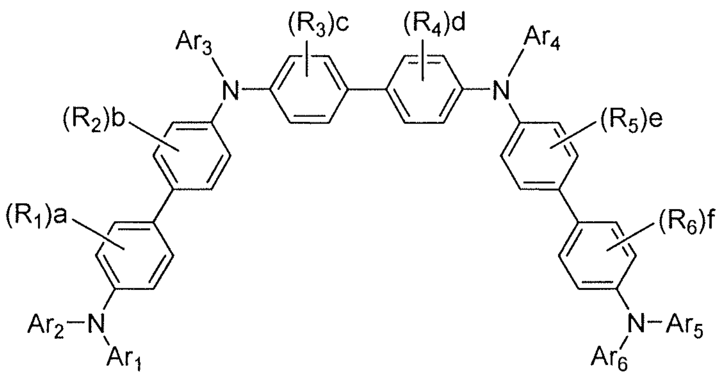

(1)

wherein $R_1$ to $R_6$ independently represent hydrogen, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; a, b, c, d, e, and f independently represent an integer of from 0 to 4; provided that $R_1$ to $R_6$ may be bonded to form a saturated or unsaturated substituted or unsubstituted five-membered or six-membered ring structure; and $Ar_1$ to $Ar_6$ independently represent a substituted or unsubstituted substituent having 6 to 50 nucleus atoms.

5. The organic electroluminescent device according to claim 3, wherein the aromatic amine derivative is a compound

of the following general formula (2),

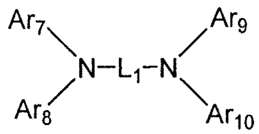

(2)

wherein $L_1$ represents a divalent group of a substituted or unsubstituted arylene group having 5 to 60 carbon atoms or a heterocyclic group, and $Ar_7$ to $Ar_{10}$ independently represent a substituted or unsubstituted substituent having 5 to 50 nucleus atoms or a substituent of the following general formula (3),

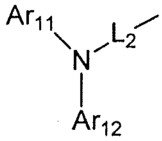

(3)

wherein $L_2$ represents a divalent group selected from a substituted or unsubstituted arylene group having 5 to 60 carbon atoms or a heterocyclic group, and $Ar_{11}$ and $Ar_{12}$ independently represent a substituted or unsubstituted substituent having 5 to 50 nucleus atoms.

**6.** The organic electroluminescent device according to claim 5, wherein at least one of $L_1$ and $L_2$ is biphenylene, terphenylene, phenanthrene, or fluorenylene.

**7.** The organic electroluminescent device according to claim 5 or 6, wherein at least one of $Ar_7$ to $Ar_{12}$ is a biphenyl group, terphenyl group, phenanthrene group, fluorenyl group, 1-naphthyl group, 2-naphthyl group, or phenyl group.

**8.** The organic electroluminescent device according to any one of claims 1 to 7, wherein the main compound which forms the second layer is an aromatic amine derivative of the following general formula (4),

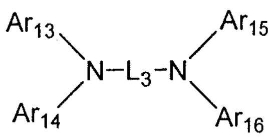

(4)

wherein $L_3$ represents a divalent group of a substituted or unsubstituted arylene group having 5 to 60 carbon atoms or a heterocyclic group; $Ar_{13}$ to $Ar_{16}$ independently represent a substituted or unsubstituted substituent having 5 to 50 nucleus atoms; and the substituent of $Ar_{13}$ to $Ar_{16}$ is a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group.

**9.** The organic electroluminescent device according to any one of claims 1 to 7, wherein the main compound which forms the second layer is an aromatic amine derivative of the following general formula (5),

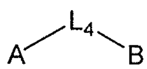

(5)

wherein A is shown by the following general formula (6), and B is shown by the following general formula (7),

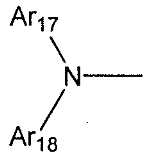

(6)

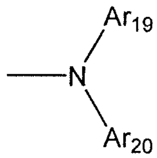

(7)

wherein $Ar_{17}$ to $Ar_{20}$ independently represent a substituted or unsubstituted substituent having 5 to 50 nucleus atoms, provided that A and B are not the same, and

$L_4$ represents a divalent group of a substituted or unsubstituted arylene group having 5 to 60 carbon atoms or a heterocyclic group.

**10.** The organic electroluminescent device according to any one of claims 1 to 7, wherein the main compound which forms the second layer is an aromatic amine derivative of the following general formula (8),

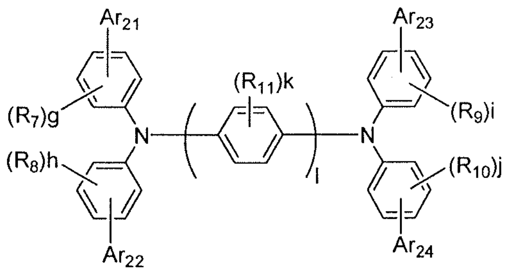

(8)

wherein $R_7$ to $R_{11}$ independently represent hydrogen, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; g, h, i, and j independently represent an integer of 0 to 4; k represents an integer of 0 to 4; l represents an integer of 1 to 3; provided that $R_7$ to $R_{11}$ may be bonded to form a saturated or unsaturated substituted or unsubstituted five-membered or six-membered ring structure; and $Ar_{21}$ to $Ar_{24}$ independently represent a substituted or unsubstituted substituent having 5 to 50 nucleus atoms.

**11.** The organic electroluminescent device according to any one of claims 1 to 7, wherein the main compound which forms the second layer is an aromatic amine derivative of the following general formula (9),

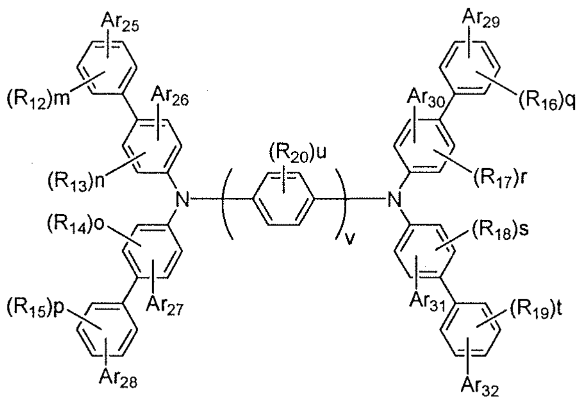

(9)

wherein $R_{12}$ to $R_{20}$ independently represent a hydrogen atom, a substituted or unsubstituted aryl group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 1 to 50 carbon atoms, a substituted or unsubstituted aryloxy group having 5 to 50 nucleus atoms, a substituted or unsubstituted arylthio group having 5 to 50 nucleus atoms, a substituted or unsubstituted carboxyl group having 1 to 50 carbon atoms, an amino group substituted by a substituted or unsubstituted aryl group having 5 to 50 nucleus atoms, a halogen group, a cyano group, a nitro group, or a hydroxyl group; m, p, q, and t independently represent an integer of 0 to 4; n, o, r, s, and u independently represent an integer of 0 to 3; v represents an integer of 1 to 3; provided that $R_{12}$ to $R_{20}$ may be bonded to form a saturated or unsaturated substituted or unsubstituted five-membered or six-membered ring structure; and $Ar_{25}$ to $Ar_{32}$ independently represent a substituted or unsubstituted substituent having 5 to 50 nucleus atoms.

**12.** The organic electroluminescent device according to any one of claims 1 to 11, wherein the first layer has a thickness of 40 to 1000 nm.

**13.** The organic electroluminescent device according to any one of claims 1 to 12, wherein the second layer has a thickness of 2 to 60 nm.

**14.** The organic electroluminescent device according to any one of claims 1 to 13, wherein the main compound which forms the first layer has an ionization potential lower than the ionization potential of the main compound which forms the second layer.

**15.** The organic electroluminescent device according to any one of claims 1 to 14, wherein the main compound which forms the second layer has a singlet energy gap of 3.0 to 3.8 eV, which is greater than the singlet energy gap of the main compound which forms the first layer.

**16.** The organic electroluminescent device according to any one of claims 1 to 15, wherein the main compound which forms the second layer has a triplet energy gap of 2.5 eV or more.

**17.** The organic electroluminescent device according to any one of claims 1 to 16, wherein the emitting layer contains an arylamine compound and/or a styryl amine compound.

**18.** The organic electroluminescent device according to any one of claims 1 to 17, which emits blue light.

FIG.1

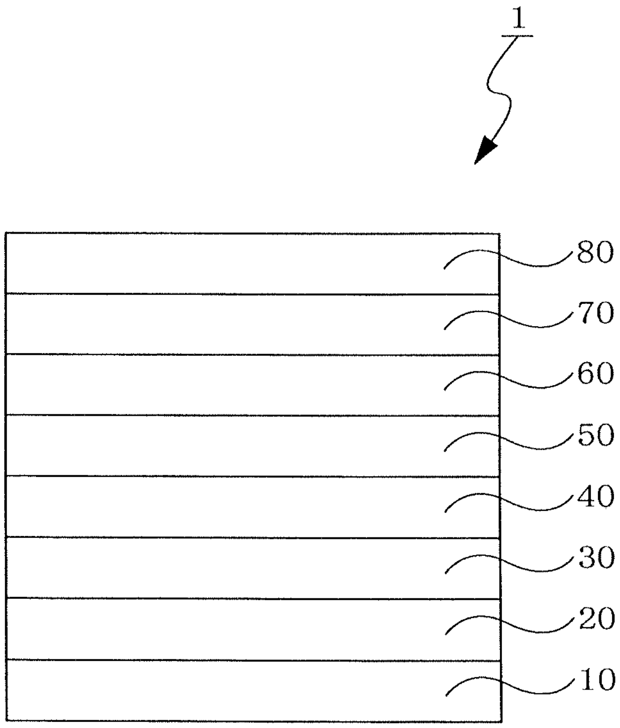

**INTERNATIONAL SEARCH REPORT**

International application No.
PCT/JP2006/309735

A. CLASSIFICATION OF SUBJECT MATTER
*H01L51/50*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-75580 A (Idemitsu Kosan Co., Ltd.), 11 March, 2004 (11.03.04), Page 21; example 3 (Family: none) | 1-3,5-18<br>4 |
| Y | JP 2005-166680 A (TDK Corp.), 23 June, 2005 (23.06.05), Page 8; compound VII; Par. Nos. [0113] to [0118] (Family: none) | 1-18 |
| Y | JP 2005-26121 A (Fujitsu Ltd.), 27 January, 2005 (27.01.05), Page 4, structural formula 4 (Family: none) | 1-18 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 August, 2006 (25.08.06) | 05 September, 2006 (05.09.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2006/309735

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-216683 A (TDK Corp.), 11 August, 2005 (11.08.05), Claim 5 (Family: none) | 1-18 |
| P,A | JP 2005-294188 A (Sony Corp.), 20 October, 2005 (20.10.05), Chemical formula 10; table 1 (Family: none) | 1-18 |
| A | JP 11-222590 A (Chisso Corp.), 17 August, 1999 (17.08.99), Claims 1, 6 (Family: none) | 1-18 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 4308688 A
- JP 7126226 A
- JP 2005166680 A


### Non-patent literature cited in the description


- **C. W. TANG ; S. A. VANSLYKE.** *Applied Physics Letters,* 1987, vol. 51, 913